# EUROPÄISCHE PATENTSCHRIFT

(11) **EP 1 121 001 B1**
(45) Veröffentlichungstag und Bekanntmachung des Hinweises auf die Patenterteilung: **06.11.2002**
(21) Anmeldenummer: 00127857.1
(22) Anmeldetag: 20.12.2000
(51) Int. Cl.: H05B 37/00, H03K 17/16, B60D 1/62, H05B 41/295

(54) **Elektronischer Schalter**
Electronic switch
Commutateur électronique

(30) Priorität: 21.01.2000 DE 10002507
(43) Veröffentlichungstag der Anmeldung: 01.08.2001
(73) Patentinhaber: GIRA GIERSIEPEN GmbH. & CO. KG., D-42477 Radevormwald (DE)
(72) Erfinder: Dornseiff, Andre, 42499 Hückeswagen (DE)
(74) Vertreter: Zapf, Christoph, Dipl.-Ing.

(56) Entgegenhaltungen:
- EP-A- 0 397 241
- EP-A- 0 483 650
- US-A- 4 649 321

## Beschreibung

Die vorliegende Erfindung betrifft einen elektronischen Schalter mit Zweidrahtanschluß zum Schalten von Lasten mit niedriger oder hoher Impedanz, wie Glühlampen oder Leuchtstofflampen, mit einer zum Ein- oder Ausschalten der Last ansteuerbaren Schalteinrichtung mit mindestens einem in Reihe zu der Last und an einer Schalter-Eingangswechselspannung liegenden Schaltelement, einer Steuerschaltung zum Ansteuern der Schalteinrichtung sowie einer Spannungsversorgung zur internen Schalter-Eigenversorgung mit einer Betriebsgleichspannung aus der Eingangswechselspannung mittels einer über die Last nachladbaren Spannungspufferung.

Solche elektronischen Schalter sollen als Austauschgeräte für herkömmliche elektromechanische Schalter dienen. Letztere arbeiten in Zweidrahttechnik, d.h. sie liegen zum Schalten zwischen dem Phasenleiter und einem Schaltleiter zur Last. In einer herkömmlichen Gebäudeinstallation sind daher in der Regel auch jeweils nur die zwei Leitungen in den Schalterdosen vorhanden. Bei einem elektromechanischen Schalter ist aber im AUS-Zustand der Strom über die Last und damit auch über den Schalter gleich Null. Im EIN-Zustand ist demgegenüber die am Schalter abfallende Spannung gleich Null. Beide Zustände bieten somit schlechte Voraussetzungen für die notwendige Eigenversorgung eines elektronischen Schalters.

Die EP-A-0 760 498 bzw. die dazu parallele US-A- 5,557,173 beschreibt einen elektronischen Schalter, bei dem als Schaltelement ein Triac vorgesehen ist, der in Reihe zu der Last an der Netzspannung liegt, und dessen Gate von der Steuerschaltung über einen Optokoppler angesteuert wird. Die Steuerschaltung ist dabei speziell als Infrarot-Sensor zum Detektieren von Personen ausgebildet. Bei diesem bekannten Schalter wird zur Eigenenergieversorgung im EIN-Zustand offensichtlich ein Phasenanschnitt mit kleinem Zündverzugswinkel genutzt. Dieser Phasenanschnitt wird in jeder Halbwelle des Laststroms erzeugt und überlagert diesen mit steilen Schaltflanken. Diese Schaltflanken beinhalten störende Oberwellen, die bis in den MHz-Bereich reichen. Die Pegel dieser Oberwellen überschreiten dort teilweise die nach dem europäischen EMV-Gesetz festgelegten Grenzwerte. Zur Dämpfung dieser Oberwellen werden zusätzliche Bauelemente, wie z. B. eine Drosselspule, erforderlich. Bedingt durch den Umstand, daß eine solche Drosselspule den gesamten Laststrom führen müßte, wäre sie relativ voluminös.

in der älteren deutschen Patentanmeldung DE 198 37 608 ist ebenfalls ein elektronischer Schalter vorgeschlagen worden, der unter Verwendung eines Triac als Schaltelement seine Eigenenergieversorgung im EIN-Zustand mittels eines laststromgesteuerten Phasenanschnitts mit kleinem Zündverzugswinkel sicherstellt. Auch hier wird der Phasenanschnitt in jeder Halbwelle des Lastromes erzeugt, so daß steile Schaltflanken mit störenden Oberwellen bis in den MHz-Bereich entstehen. Auch dieser Schalter ist deshalb nach dem europäischen EMV-Gesetz eher ungünstig. Da das Schaltelement in diesem Schalter laststromgesteuert gezündet wird, kann es bei verzerrten oder unsauberen Strömen, wie sie beispielsweise von Energiesparlampen aufgenommen werden, im Bereich des Zündstromes zu einem Dauerzünden bzw. Dauersperren des Schaltelementes kommen.

In der DE 34 32 225 ist ein nicht gattungsgemäßer Schalter beschrieben, da dieser einen zusätzlichen Null-Leiter benötigt, also in Dreidrahttechnik arbeitet. Dieser Schalter und Phasenabschnittdimmer verwendet als Leistungsschaltelement zwei antiseriell, in Reihe geschaltete sogenannte nichtregenerative Leistungshalbleiter. Dabei handelt es sich um Halbleiter wie Transistoren, die nicht wie ein Triac selbstständig nach einmaligem Zünden den Laststrom bis zu seinem Nulldurchgang halten, sondern sich auch bei einem Laststrom ungleich Null abschalten lassen. Mit diesem Schalter ist deshalb auch ein Dimmbetrieb in Phasenabschnitt-Technik möglich. Dazu schaltet die Steuerelektronik die Leistungshalbleiter jeweils im Nulldurchgang der Netzwechselspannung ein und nach einer definierten Zeit innerhalb der folgenden Netzhalbwelle wieder aus. Zur Vermeidung der oben beschriebenen EMV-Probleme werden die Leistungshalbleiter jeweils mit einer definierten Geschwindigkeit "weich" ausgeschaltet, so daß sie den Laststrom nur allmählich zu Null kommen lassen. Der Nachteil dieses Schalters ist der erforderliche dritte Leiter.

Andere als Phasenabschnittdimmer in Zweidrahttechnik arbeitende Schalter nutzen die Strompause nach dem Phasenabschnitt bis zum nächsten Nulldurchgang zur Eigenversorgung. In diesem Zeitraum ist der Strom nicht wirklich Null, sondern entweder stark vermindert oder nur als kurzzeitiger Impuls vorhanden. Er reicht zur Schalterversorgung aus. Von Nachteil ist aber hier bei Verwendung als Schalter, daß der Phasenabschnitt zur Eigenversorgung auf jeden Fall erzeugt werden muß und der Last somit nicht die gesamte Netzspannung zur Verfügung steht. Die Stromunterbrechung nach dem Phasenabschnitt ist für induktive Lasten ungeeignet, da diese im Falle einer Stromunterbrechung störende Überspannung erzeugen würden (Induktion).

Der vorliegenden Erfindung liegt die Aufgabe zugrunde, einen elektronischen Schalter in Zweidrahttechnik zu schaffen, der eine sichere Eigenversorgung ohne, zumindest aber mit deutlich reduzierten EMV-Störungen gewährleistet.

Erfindungsgemäß wird dies durch einen Nachladeinitiator erreicht, der zur Eigenversorgung im eingeschalteten Zustand der Last in an den inneren Energiebebedarf angepassten Zeitabständen jeweils einen Nachladevorgang der Spannungspufferung auslöst, indem jeweils kurzzeitig die Schalteinrichtung zum Abschalten des bzw. jedes Schaltelementes angesteuert und die Betriebsgleichspannung über einen alternativen Strompfad gewonnen wird. Vorzugsweise werden dabei in jedem Nachladevorgang die Schalteelemente jeweils weich, d. h. mit definierter Geschwindigkeit bzw. bewußt schräger Schaltflanke, ausgeschaltet und nach dem Nachladevorgang auch wieder entsprechend weich eingeschaltet. Während des Nachladevorgangs fließt der gegenüber dem tatsächlichen Laststrom nur minimal verminderte Strom kurzzeitig über einen alternativen Strompfad durch den Schalter, wodurch induktive Lasten keine störenden Überspannungen mehr erzeugen können. Erfindungsgemäß erfolgt das Nachladen der Spannungspufferung nicht mehr in jeder Halbwelle, sondern die Nachladung ist dem Stromverbrauch des Schalters angepasst. Es kann dadurch eine deutliche Reduzierung der Anzahl von Nachladevorgängen und dadurch eine Minimierung von Schaltverlusten erreicht werden. In einer ersten Ausführungsform kann dies dadurch erfolgen, daß der Nachladeinitiator die Nachladevorgänge jeweils "echt" bedarfsabhängig in Abhängigkeit von der Höhe der Betriebsgleichspannung über eine Bedarfssteuerung auslöst. Bei dieser Ausführung sind die Zeitabstände der Nachladevorgänge somit nicht fest vorgegeben, sondern sie ergeben sich von selbst in echter Abhängigkeit vom tatsächlichen Energiebedarf. Dazu weist die Bedarfssteuerung eine Spannungsüberwachung für die Betriebsgleichspannung derart auf, daß bei Erreichen oder Unterschreiten eines bestimmten Schwellwertes der Betriebsgleichspannung selbsttätig über den Nachladeinitiator ein Nachladevorgang ausgelöst wird.

Alternativ dazu ist es ebenfalls möglich, daß der Nachladeinitiator die Nachladevorgänge jeweils zeitgesteuert in vorbestimmten, dabei aber an den zuvor ermittelten Energiebedarf angepassten Zeitabständen über eine Zeitsteuerung auslöst.

Weitere vorteilhafte Ausgestaltungsmerkmale der Erfindung sind in den Unteransprüchen sowie der folgenden Beschreibung enthalten.

Anhand der Zeichnung soll die Erfindung beispielhaft genauer erläutert werden. Dabei zeigen:
- Fig. 1: ein Blockschaltbild eines erfindungsgemäßen elektronischen Schalters mit obligatorischen sowie zusätzlichen, optionalen Komponenten,
- Fig. 2: ein Blockschaltbild der Steuerschaltung,
- Fig. 3: ein Blockschaltbild des Nachladeinitiators in einer ersten Ausführungsform,
- Fig. 4: ein Blockschaltbild einer zweiten Ausführung des Nachladeinitiators,
- Fig. 5: Diagramme zur Erläuterung der Schaltvorgänge in einer ersten Variante des erfindungsgemäßen Schalters,
- Fig. 6: Diagramme ähnlich Fig. 5 zu einer zweiten Variante des Schalters,
- Fig. 7: weitere Diagramme bezüglich einer dritten Variante des Schalters,
- Fig. 8: Diagramme zu einer vierten Schaltervariante,
- Fig. 9: eine detailliertere Schaltung der Schalteinrichtung,
- Fig. 10: eine mögliche Schaltung eines nur bevorzugt vorgesehenen Treibers,
- Fig. 11: eine weitere Detailschaltung eines der in Fig. 1 enthaltenen Blöcke, und zwar u. a. des alternativen Strompfades,
- Fig. 12: ein Schaltbild der Spannungspufferung mit Stabilisierung,
- Fig. 13: eine Schaltung eines bevorzugt vorgesehenen Spannungserhöhers,
- Fig. 14: einen eventuell vorgesehenen zusätzlichen Kurzschlußschutz,
- Fig. 15: die Schaltung eines Steuerteils zum Veranlassen eines Ein- oder Ausschaltvorgangs der Last (hier sogenannte Sensorauswertung),
- Fig. 16: eine Reset-Schaltung,
- Fig. 17: eine Schaltung zur Schwellwerterkennung (Spannung und Laststrom),
- Fig. 18: eine Alternative zur Schwellwerterkennung der Spannung,
- Fig. 19: eine Spannungsüberwachung für die Betriebsspannung,
- Fig. 20: eine erste Ausführung einer Steuerlogik zur Ansteuerung der Schalteinrichtung,
- Fig. 21: eine zweite Variante der Steuerlogik,
- Fig. 22: eine dritte Variante der Steuerlogik,
- Fig. 23: eine weitere Schaltungseinzelheit (Rampengenerator) und
- Fig. 24: eine weitere Einzelheit der Steuerlogik.

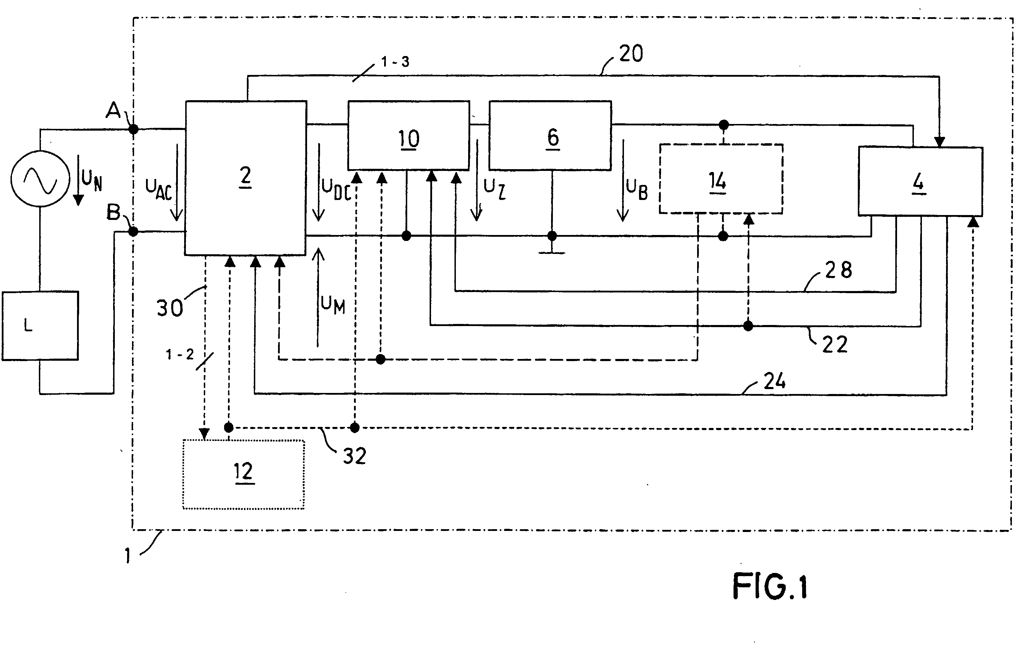

Wie sich zunächst aus Fig. 1 ergibt, wird ein erfindungsgemäßer elektronischer Schalter, der insgesamt mit der Bezugsziffer 1 bezeichnet und mit einer Strichpunktlinie umrahmt ist, in Reihe zu einer Last L an eine Spannung, üblicherweise an eine Netzwechselspannung U_{N} mit 230 V, 50 Hz, angeschlossen. Dazu weist der Schalter 1 - wie ein üblicher elektromechanischer Schalter - nur zwei Klemmen A und B auf, von denen die eine (A) direkt mit der Netzspannung U_{N} und die andere (B) mit der Last L und über diese mittelbar mit der Netzspannung U_{N} verbunden sind. Am Schalter 1 liegt somit eine Schalter-Eingangswechselspannung U_{AC} an, die im EIN-Zustand im Vergleich zur der an der Last L abfallenden Spannung relativ klein ist.

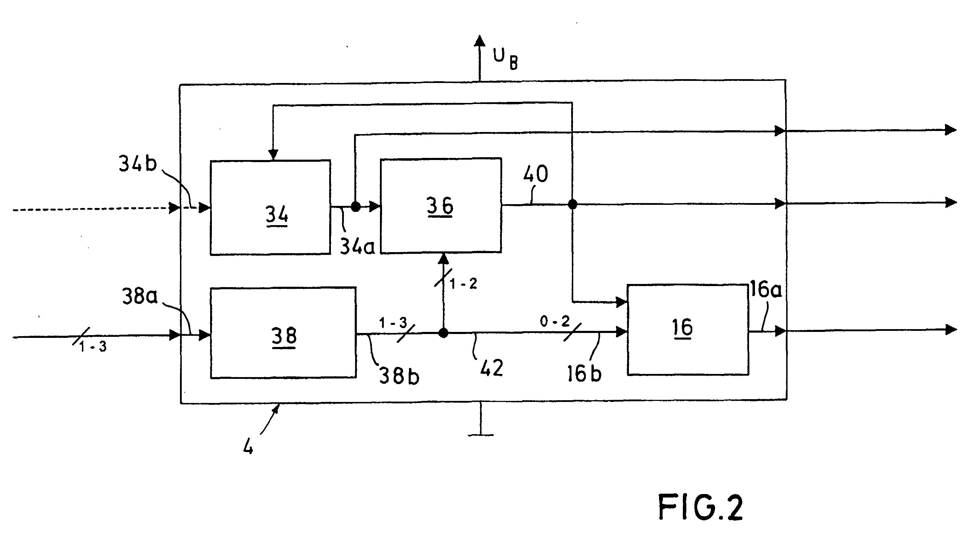

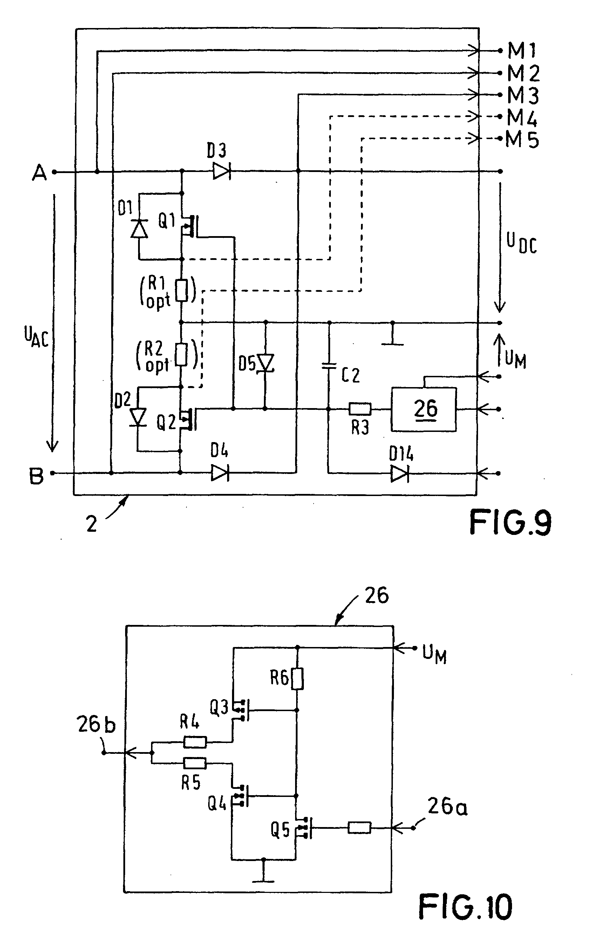

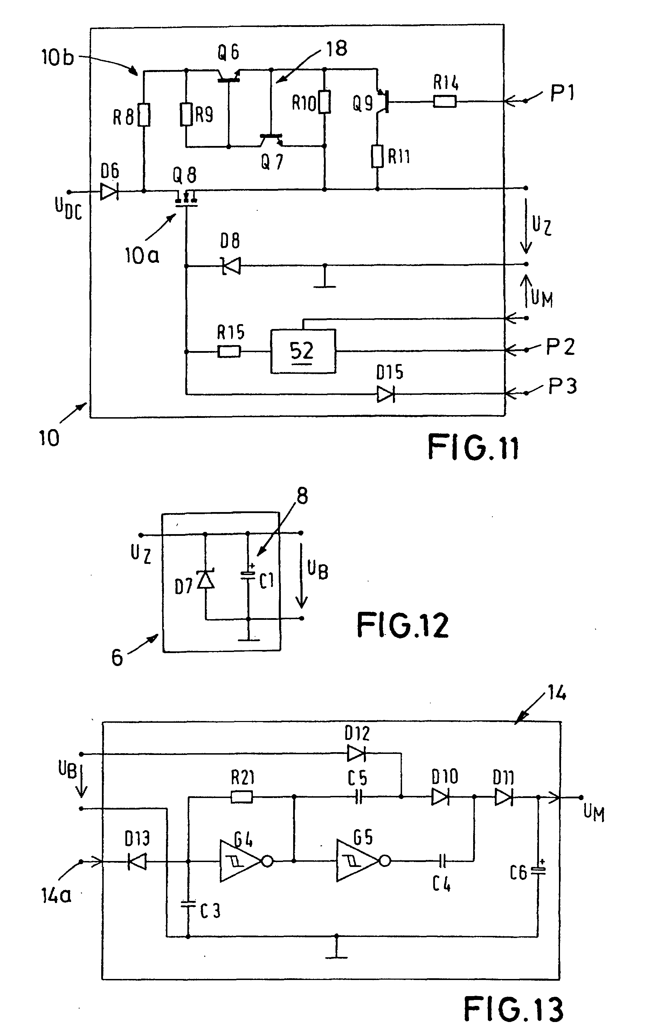

Der erfindungsgemäße Schalter 1 enthält zumindest folgende Komponenten:
- eine zum Ein- oder Ausschalten der Last L ansteuerbare Schalteinrichtung 2 mit vorzugsweise zwei antiseriell in Reihe zu der Last L und somit an der Eingangswechselspannung U_{AC} liegenden Schaltelementen Q1, Q2 (vgl. dazu Fig. 9),
- eine Steuerschaltung 4 (vgl. auch Fig. 2 ) zum Ansteuern der Schalteinrichtung 2,
- eine Spannungsversorgung 6 zur internen Schalter-Eigenversorgung mit einer Betriebsgleichspannung U_{B} aus der Eingangswechselspannung U_{AC} mittels einer über die Last L nachladbaren Spannungspufferung 8 (vgl. Fig. 12),
- einen Block "hochohmiger / alternativer Strompfad" 10, der gemäß Fig. 11 einen alternativen Strompfad 10a und einen hochohmigen Strompfad 10b enthält und im Folgenden noch genauer erläutert werden wird.

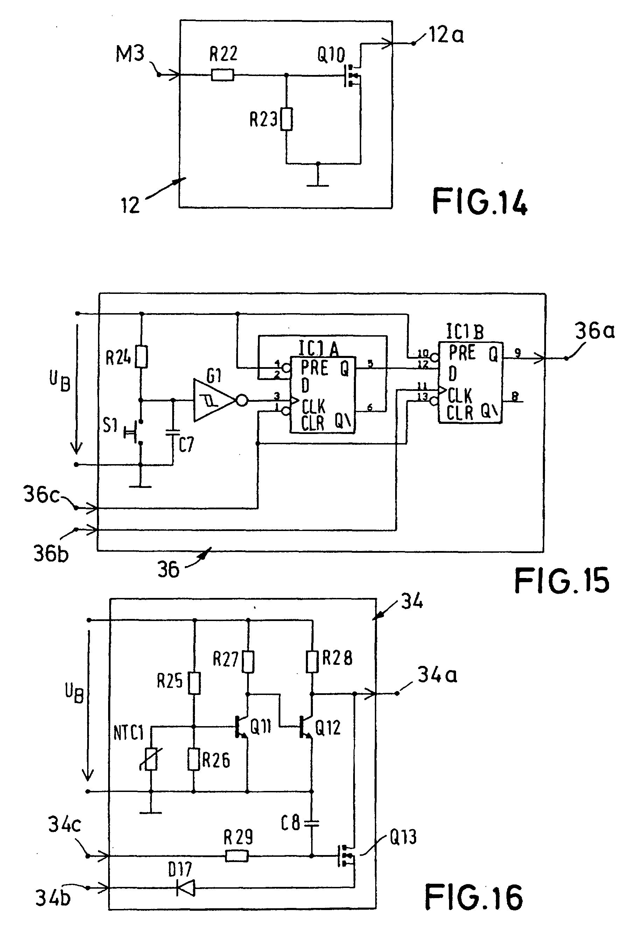

Optional kann der Schalter 1 zudem einen Kurzschluß- und Überlastschutz 12 enthalten (vgl. Fig. 14). Femer kann bevorzugt ein Spannungserhöher 14 vorgesehen sein (vgl. auch Fig. 13). Diese Komponenten werden noch genauer erläutert werden.

Für die Schaltelemente der Schalteinrichtung 2 werden bevorzugt MOSFET oder IGBT verwendet. Zudem weist die Schalteinrichtung 2 eine Gleichrichterbeschaltung D1 bis D4 (Fig. 9) auf, die bei abgeschalteter Schalteinrichtung 2 aus der Eingangswechselspannung U_{AC} eine Eingangsgleichspannung U_{DC} zur Einspeisung in den hochohmigen / alternativen Strompfad 10 erzeugt. In einer alternativen Ausführung kann die Schalteinrichtung 2 auch nur einen in den DC-Pfad einer Gleichrichterbrücke geschalteten Transistor enthalten, wobei die gleichgerichtete Spannung am Transistor ebenfalls zur Versorgung der weiteren Schalterelektronik genutzt wird.

Erfindungsgemäß ist ein spezieller Nachladeinitiator 16 - beispielsweise als Bestandteil der Steuerschaltung 4 (Fig. 2) - vorgesehen, der zur Eigenversorgung im eingeschalteten Zustand der Last L jeweils in an den inneren Energiebedarf angepassten Zeitabständen Nachladevorgänge der Spannungspufferung 8 auslöst. Dazu wird jeweils kurzzeitig die Schalteinrichtung 2 zum Abschalten der Schaltelemente Q1, Q2 angesteuert, und der Strom wird dann während dieser Nachladevorgänge jeweils über den alternativen Strompfad 10a geführt, um die Betriebsgleichspannung U_{B} zu gewinnen.

Im Gegensatz dazu wird im ausgeschalteten Zustand der Last L ein dann über die Last L fließender, relativ geringer Versorgungsstrom zur Erzeugung der Betriebsgleichspannung U_{B} über den hochohmigen Strompfad 10b geführt. Vorzugsweise enthält dazu der hochohmige Strompfad 10b eine Stromquelle 18 derart, daß der Versorgungsstrom nahezu unabhängig von der Impedanz der jeweiligen Last L im Wesentlichen konstant ist. Der Versorgungsstrom sollte etwa im Bereich von 100 bis 300 µA liegen, beispielsweise etwa 200 µA.

Der Strompfad 10 enthält gemäß Fig. 11 zudem ein Schaltelement Q8, vorzugsweise ein Halbleiterelement, wie MOSFET, IGBT oder Bipolartransistor, um für die Nachladevorgänge im EIN-Zustand der Last L den alternativen Strompfad 10a wirksam zu machen oder im AUS-Zustand der Last L den hochohmigen Strompfad 10b. In beiden Schaltzuständen generiert dieser Block 10 aus der Eingangsgleichspannung U_{DC} eine Zwischenspannung U_{Z,} aus der dann die Betriebsgleichspannung U_{B} erzeugt wird. Gemäß Fig. 12 ist als Spannungspufferung 8 ein Kondensator C1 vorgesehen, dem zur Spannungsstabilisierung eine Zener-Diode D7 parallel geschaltet ist.

Wie sich weiterhin aus Fig. 1 ergibt, ist die Schalteinrichtung 2 mit der Steuerschaltung 4 über eine Signalverbindung 20 verbunden, über die Signale "Spannungs-/Laststromwerte" übertragen werden. Hierüber kann die Steuerschaltung 4 die Spannung am Schalter 1 und/oder den Laststrom durch den Schalter 1 überwachen. Dadurch ist es vorteilhafterweise möglich, bei Schalterbetätigung die Schaltelemente für eine lastschonende Ansteuerung im Nulldurchgang der Spannung ein- und im Nulldurchgang des Laststromes auszuschalten. Die Nachladevorgänge, in denen die Schaltelemente abgeschaltet werden und der dann über die Last L fließende Strom über den alternativen Strompfad 10a fließt, können entweder zu beliebigen Phasenwinkeln des Stromes eingeleitet werden ober aber bevorzugt synchronisiert mit dem Strom in der Nähe seiner Nulldurchgänge. Je nach Realisierungsart werden ein bis drei "Spannungs-/Laststromwerte" benötigt.

Der gegebenenfalls vorhandene Spannungserhöher 14 erzeugt aus der relativ geringen Spannung U_{B} eine höhere Ansteuerspannung für die Schaltelemente, für die deshalb vorteilhafterweise MOSFET oder IGBT verwendet werden können, die eine Gate-Spannung U_{M} von 10 V bis 15 V benötigen. Die Steuerschaltung 4 kann in diesem Fall mit einer sehr kleinen Spannung U_{B} beispielsweise im Bereich von 3 V bis 5 V arbeiten, denn je kleiner die Spannung zur Eigenversorgung ist, desto geringer ist auch ihr Stromverbrauch und desto geringer ist die am Schalter 1 insgesamt abfallende Spannung während der Nachladevorgänge. Im AUS-Zustand der Last L wird die erhöhte Spannung U_{M} zur Ansteuerung der Schaltelemente nicht benötigt, so daß dann der Spannungserhöher 14 abgeschaltet werden kann.

Die Steuerschaltung 4 ist über eine weitere Signalverbindung 22 mit dem Block 10 und gegebenenfalls mit dem Spannungserhöher 14 verbunden. Ein hierüber übertragenes Signal "Schalter ein/aus" gibt den Schaltzustand des Schalters an und steuert entsprechend den "hochohmigen oder alternativen Strompfad" 10 an. Im AUS-Zustand ist der alternative Strompfad 10a abgeschaltet, während der hochohmige Strompfad 10b den kleinen Versorgungsstrom regelt. Im EIN-Zustand wird der alternative Strompfad 10a niederohmig geschaltet. Falls vorhanden, wird durch dieses Signal im EIN-Zustand auch der Spannungserhöher 14 aktiviert.

Die Steuerschaltung 4 ist zudem noch über eine weitere Signalverbindung 24 mit der Schalteinrichtung 2 verbunden, über die ein Signal "Schaltelement ein/aus" übertragen wird, welches grundsätzlich mit dem Signal "Schalter ein/aus" übereinstimmt. Dieses Signal steuert nur die Schaltelemente der Schalteinrichtung 2 an, wird aber im Gegensatz zum Signal "Schalter ein/aus" im EIN-Zustand während des Nachladevorgangs auf LOW geschaltet, wodurch die Schaltelemente hochohmig werden und der Strom über die Last und über den alternativen Strompfad 10a zum Nachladen der Spannungspufferung 8 fließt.

Während des Nachladevorgangs fallen an dem Schalter 1 zusätzlich zu den Flußspannungen an den Schaltelementen Q1, Q2 (MOSFET o. ä.) die Spannung U_{B} aus der Spannungspufferung 8 und die Flußspannungen der Gleichrichterdioden D1 bis D4 ab. Diese Gesamtspannung wirkt als Gegenspannung zur Netzspannung, reduziert aber vorteilhafterweise den Laststrom nur wenig, da sie erstens vom Betrag her viel kleiner als die Netzspannung ist und zweitens nur kurzzeitig für die Zeit des Nachladevorgangs von z. B. nur etwa 1 ms erzeugt wird. Die in der Last L umgesetzte Energie vermindert sich damit kaum, eine Reduzierung der Helligkeit eines Leuchtmittels ist nicht wahrnehmbar. Sind die Schaltelemente der Schalteinrichtung 2 eingeschaltet, fließt der Laststrom früher durch sie als über den alternativen Strompfad 10a, da der Widerstand der Schaltelemente in diesem Zustand bedeutend geringer ist als derjenige des alternativen Strompfades 10a.

Sofern der Spannungserhöher 14 vorhanden ist, wird die dort erzeugte Spannung U_{M} der Schalteinrichtung 2 und - je nach Realisierungsart - auch dem Block Strompfad 10 zugeführt. Über entsprechende Treiber 26 (Fig. 9 und 10) werden dann die Schaltelemente über die Steuersignale aus der Steuerschaltung 4, deren HIGH-Pegel nur den Wert U_{B} hat, mit der Spannung U_{M} angesteuert.

Die Steuerschaltung 4 ist ferner über eine weitere Signalverbindung 28 mit dem Block Strompfad 10 verbunden, um ein Signal "Reset" zu übertragen, welches für eine Umschaltung des vom hochohmigen Strompfad 10b geregelten Stromes auf einen größeren Wert von etwa 1 mA sorgt. Dies ist beim Anklemmen des Schalters 1 an die Netzspannung erforderlich, d. h. zum Hochfahren der Betriebsspannung U_{B}, da die vorzugsweise in der Steuerschaltung 4 verwendeten CMOS-Gatter bei Spannungen, die unterhalb ihrer Nennspannungen liegen, mehr Strom verbrauchen. Das Umschalten auf einen höheren Strom sorgt damit für ein sicheres Hochfahren des Schalters 1.

Der nur vorzugsweise vorgesehene Kurz- und Überlastschutz 12 sorgt bei einem Kurzschluß oder einer Überlast für ein selbsttätiges Abschalten des Schalters 1. Im Falle eines Kurzschlusses muß der Schalter sehr schnell in den AUS-Zustand überführt werden, um eine Überlastung der Schaltelemente (Leistungshalbleiter) zu vermeiden. Bei einer Überlast erwärmen sich die Leistungshalbleiter stark, was auf lange Dauer zu deren Zerstörung führen würde. In diesem Fall muß der Überlastschutz allmählich für ein Abschalten des Schalters sorgen.

Dazu ist der Block 12 über eine Signalverbindung 30 mit der Schalteinrichtung 2 verbunden, um über Signale "Kurzschluß- und Überlaststromwerte" den Laststrom zu überwachen. Je nach Realisierungsart sind entweder nur ein Signal zur gemeinsamen Überwachung beider Laststromhalbwellen oder zwei Signale zur getrennten Überwachung der positiven und negativen Laststromhalbwellen erforderlich. Über weitere Signalverbindungen 32 wird ein im Falle eines Kurzschlusses oder einer Überlast erzeugtes Signal "Schalter aus" direkt zum Abschalten an die Schalteinrichtung 2 geleitet und je nach Realisierungsart auch zum Abschalten zum Block Strompfad 10. Des weiteren versetzt dieses Signal auch den Schaltzustand der Steuerschaltung 4 in den AUS-Zustand.

Es soll nun das in Fig. 2 dargestellte Blockschaltbild der Steuerschaltung 4 erläutert werden. Demnach besteht die Steuerschaltung 4 aus den Blöcken Reset-Schaltung 34, Sensorauswertung 36, Schwellwerterkennung (en) 38 sowie dem bereits erwähnten Nachladeinitiator 16.

Die Reset-Schaltung 34 setzt zur Vermeidung von undefinierten Schaltzuständen den Schalter 1 beim Hochfahren der Betriebsspannung U_{B} in den AUS-Zustand. Dazu erzeugt sie an ihrem Ausgang 34a das Signal "Reset". An ihrem Eingang 34b erhält sie gegebenenfalls das Signal "Schalter aus" vom Kurzschluß- und Überlastschutz 12, worauf sie ebenfalls das Signal "Reset" generiert. Je nach-Realisierungsart des Kurzschluß- und Überlastschutzes 12 kann das Signal "Schalter aus" im AUS-Zustand des Schalters dauerhaft aktiv sein. In diesem Fall schaltet das Signal "Schalter ein/aus" (auf Leitung 40) das Signal "Schalter aus" von der Reset-Schaltung 34 ab, womit ein Einschalten des Schalters möglich wird.

Der Block 38 Schwellwerterkennung erzeugt in Abhängigkeit von seinem Eingang 38a zugeführten Signalen "Spannungs-/Laststromwerte" an seinem Ausgang 38b die Signale 20 "Spannungs-/Laststromschwellwertimpulse" (Fig. 1). Diese werden über Verbindungen 42 der Sensorauswertung 36 und dem Nachladeinitiator 16 zugeführt. Diese Impulse werden ab Über- oder Unterschreitung bestimmter Absolutwerte generiert und synchronisieren interne Schaltvorgänge mit der Frequenz bzw. mit bestimmten Phasenwinkeln der Netzspannung und des Laststromes. Zum Einschalten im Nulldurchgang der Netzspannung enthält dieser Block 38 eine Spannungsnulldurchgangserkennung, die ab Über- oder Unterschreitung einer Spannungsschwelle nahe Null einen Schwellwertimpuls erzeugt. Zum Abschalten im Nulldurchgang des Laststromes ist eine Stromnulldurchgangserkennung vorhanden, die ab Über- oder Unterschreitung einer Laststromschwelle nahe Null einen Schwellwertimpuls erzeugt (vorzugsweise zwei Signale für je 1 x Laststrom positive/negative Halbwelle). Diese Schwellwertimpulse werden vorzugsweise auch für das netzsynchrone Nachladen in der Nähe der Nulldurchgänge genutzt.

Die Sensorauswertung 36 erzeugt in Abhängigkeit von einem Eingabesignal von außen (manueller Tasterbetätigung, IR-Sensor bzw. lR-Protokoll-Empfang, PIR-Personendetektion) auf der Leitung 40 ein Signal "Schalter ein/aus". Beim Einschalten wartet die Sensorauswertung 36 vorzugsweise auf den Spannungsschwellwertimpuls eines Nulldurchgangs der Netzspannung und setzt damit das Signal "Schalter ein/aus" in den EIN-Zustand. Beim Ausschalten wartet sie hingegen vorzugsweise auf den Stromschwellwertimpuls eines Stromnulldurchgangs und setzt das Signal in den AUS-Zustand.

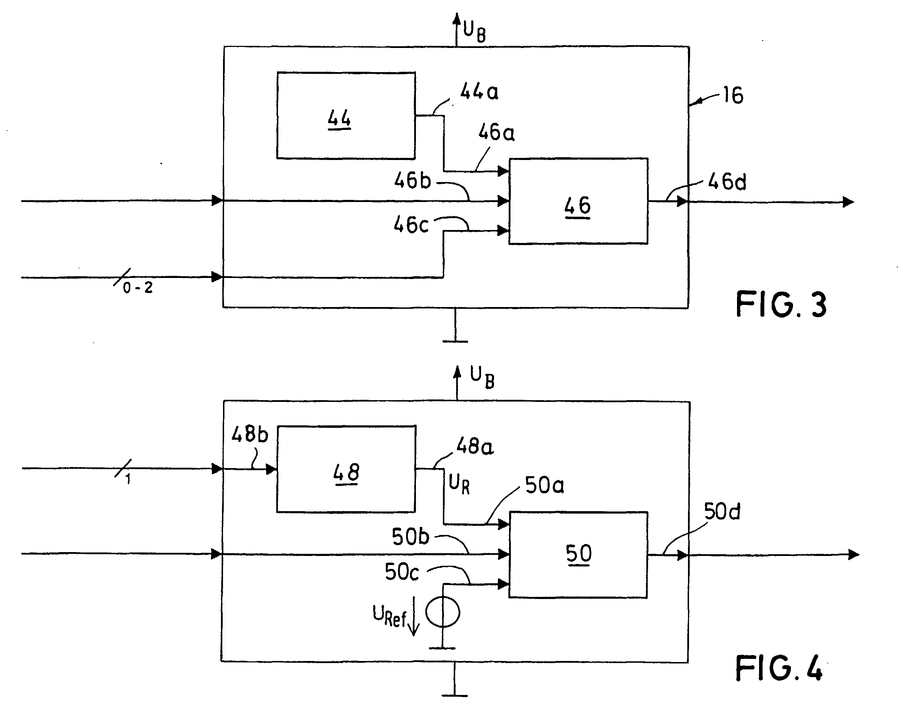

Der Nachladeinitiator generiert in Abhängigkeit vom Signal "Schalter ein/aus" an seinem Ausgang 16a das Signal "Schaltelement ein/aus". Im EIN-Zustand des Schalters sorgt der Nachladeinitiator 16 für ein Nachladen der Spannungspufferung 8, wozu er das Signal "Schaltelement ein/aus" kurzzeitig in den AUS-Zustand setzt, was die Schaltelemente der Schalteinrichtung 2 abschaltet. Je nach Realisierungsart benötigt der Nachladeinitiator 16 an seinem Eingang 16b 0 bis 2 Spannungs- oder Stromschwellimpulse, über die er die Nachladevorgänge in die Nähe der Nulldurchgänge des Laststromes verlegen kann. Der Nachladeinitiator 16 kann grundsätzlich auf zwei Arten realisiert werden, die nun anhand der Fig. 3 und 4 erläutert werden sollen.

Fig. 3 zeigt den Aufbau des Nachladeinitiators 16 für die erste Ausführungsform des erfindungsgemäßen Schalters 1, bei dem die Nachladevorgänge im EIN-Zustand echt bedarfsabhängig durchgeführt werden. Dazu enthält der Nachladeinitiator 16 die Blöcke Spannungsüberwachung 44 für die Betriebssgleichspannung U_{B} sowie Steuerlogik 46 für die Schaltetemente der Schalteinrichtung 2. Die Spannungsüberwachung 44 erzeugt in Abhängigkeit vom Spannungspegel U_{B} an seinem Ausgang 44a das Signal "Nachladeanforderung". Bei Unterschreitung einer unteren Schwelle für U_{B} wird "Nachladeanforderung" aktiv geschaltet. Bei Überschreitung einer oberen, höheren Schwelle wird das Signal inaktiv geschaltet. Zwischen oberen und unterer Schwelle existiert eine Hysterese, die in Verbindung mit dem Stromverbrauch der Steuerschaltung 4 und der Kapazität der Spannungspufferung 8 die Periode bzw. die Zeitabstände der aufeinanderfolgenden Nachladevorgänge bestimmt. Sie liegt im realisierten Aufbau beispielsweise zwischen 100 und 1000 ms.

Die Steuerlogik 46 erhält die Signale "Nachladeanforderung" am Eingang 46a, "Schalter ein/aus" am Eingang 46b und - je nach Realisierungsart - 0 bis 2 "Laststromschwellwertimpulse" am Eingang 46c. Spannungsschwellwertimpulse werden hier nicht benötigt.

Die Steuerlogik 46 erzeugt am Ausgang 46d das Signal "Schaltelement ein/aus", sofern das Signal "Schalter ein/aus" den EIN-Zustand signalisiert.

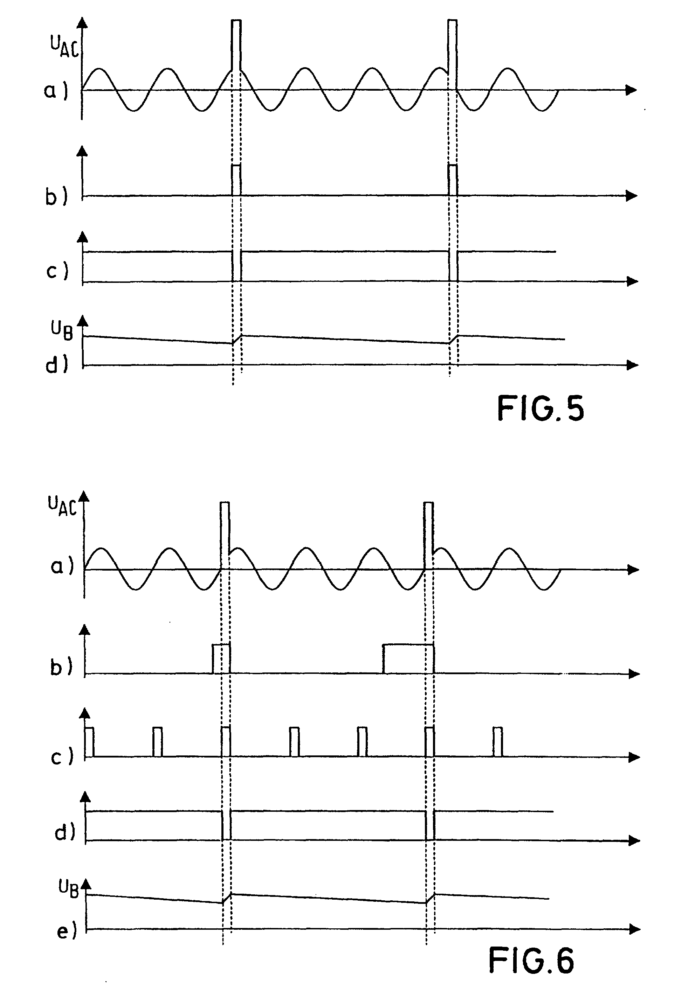

In einer einfachen, ersten Ausführungsvariante kann der Nachladevorgang unabhängig von "Laststromschwellwertimpulsen" zu beliebigen Phasenwinkeln des Laststromes erzeugt werden. Die Diagramme in Fig. 5 zeigen die zugehörigen Schaltvorgänge im Schalter. Das Diagramm a zeigt den Verlauf der Eingangswechselspannung U_{AC}, das Diagramm b das Signal "Nachladeanforderung", das Diagramm c das Signal "Schaltelement ein/aus" und schließlich das Diagramm d den Verlauf der Betriebsgleichspannung U_{B}. Bei einem Minimalwert von U_{B} wird das Signal "Nachladeanforderung" gemäß Diagramm b HIGH, worauf sofort das Signal "Schaltelement ein/aus" zurückgeschaltet wird. Der Nachladevorgang wird dann unmittelbar eingeleitet. Die Schalterspannung U_{AC}, die durch den Laststrom an den ON-Widerständen der Schaltelemente Q1, Q2 der Schalteinrichtung 2 erzeugt wird, ist hier als Sinusspannung dargestellt. Während des Nachladevorgangs erhöht sie sich um die Betriebsgleichspannung U_{B} sowie die Diodenflußspannungen auf einen höheren Wert. Der alternative Strompfad 10a und die Spannungspufferung 8 müssen für den maximalen, momentanen Laststrom ausgelegt sein, da ein Nachladevorgang hierbei unter Umständen auch im Scheitelwert des Laststromes auftreten kann.

In einer zweiten, bevorzugten Ausführungsvariante wird der Nachladevorgang in Abhängigkeit von Laststromimpulsen ausgelöst, die entweder von der positiven oder der negativen Laststromhalbwelle herrühren. Es ist nur ein Signal "Laststromschwellwertimpuls" erforderlich. Der Nachladevorgang wird vorteilhafterweise in die Nähe der Laststromnulldurchgänge verlegt. Die zugehörigen Schaltvorgänge sind in den Diagrammen gemäß Fig. 6 veranschaulicht. Im Vergleich zu Fig. 5 ist zusätzlich das Diagramm c mit dem "Laststromschwellwertimpuls" (positive Halbwelle) dargestellt. Bei Auftreten des Signals "Nachladeanforderung" (Diagramm b) wird hier zunächst auf den nächsten "Laststromschwellwertimpuls" gewartet, mit dem dann das Signal "Schaltelement ein/aus" gemäß Diagramm d auf LOW gesetzt wird. Der Nachladevorgang endet, wenn das Signal "Nachladeanforderung" gemäß Diagamm b LOW wird. Bei dieser Art des Nachladens müssen der alternative Strompfad 10a und die Spannungspufferung 8 vorteilhafterweise niemals den Scheitelwert des Laststromes aufnehmen, sondern lediglich kleine Werte in der Nähe der Nulldurchgänge. Vorteilhafterweise können dadurch die Bauteile entsprechend kleiner gewählt werden (kleinere Leistung, kleineres Volumen). Die Nachladevorgänge werden immer in Halbwellen gleicher Polarität generiert.

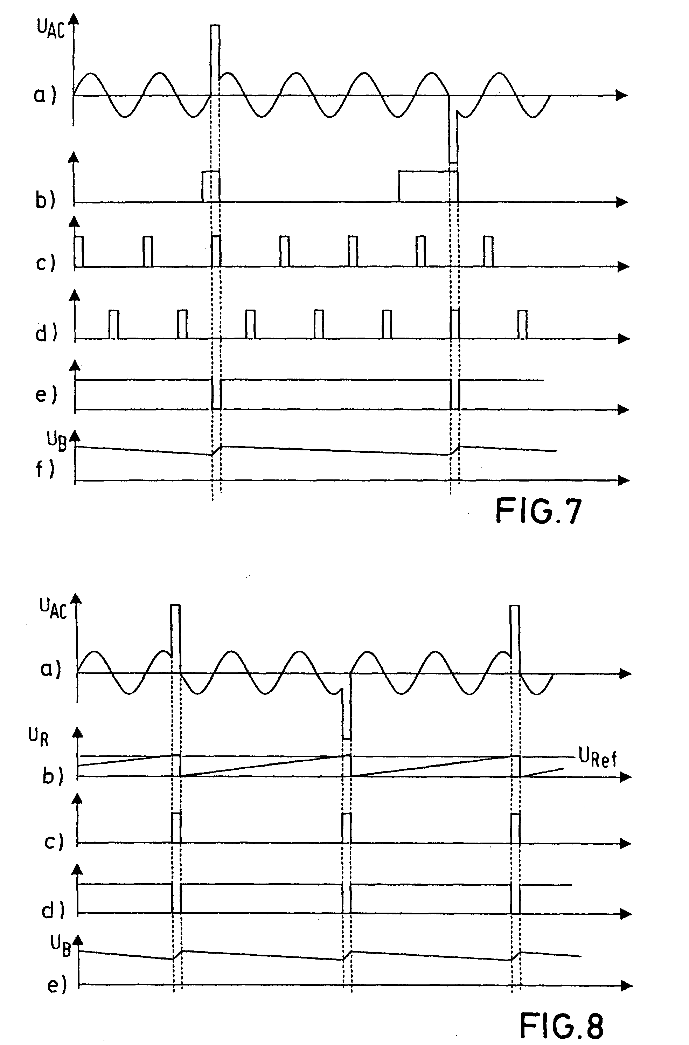

In einer dritten Ausführungsvariante werden die Nachladevorgänge in Abhängigkeit von zwei "Laststromschwellwertimpulsen" gebracht. Der Nachladevorgang wird in die Nähe der Stromnulldurchgänge gebracht. Eine zusätzliche Logik sorgt dafür, daß abwechselnd in positiven und negativen Laststromhalbwellen nachgeladen wird. Dies erhöht vorteilhafterweise die Symmetrie des Laststromes. Für die Bauteile gilt der gleiche Vorteil wie bei der zweiten Ausführungsvariante. Die Abläufe der dritten Variante sind in Fig. 7 veranschaulicht. Im Diagramm c ist das Signal "Laststromschwellwertimpuls" (positive Halbwelle) dargestellt und in d der "Laststromschwellwertimpuls" (negative Halbwelle). Nach der "Nachladeanforderung" (Diagramm b) wird bis zum "Laststromschwellwertimpuls" gewartet, der von der Halbwelle mit entgegengesetzter Polarität zum vorherigen Nachladevorgang erzeugt wird. Die Impulse wirken sich auf die Spannung U_{AC} deshalb mit immer abwechselnder Polarität aus.

Die Laststromschwellwertimpulse zur Einleitung eines Nachladevorgangs können zum einen ab Unterschreitung des betraglichen Laststromes unterhalb-einer vorgegebenen Schwelle von beispielsweise etwa 200 mA erzeugt werden, der Schalter arbeitet dann quasi in Phasenabschnitt. Zum anderen können die Laststromschwellwertimpulse, wie in den Diagrammen Fig. 5 bis Fig. 7 gezeigt, ab Überschreitung des betraglichen Laststromes oberhalb einer vorgegebenen Schwelle von beispielsweise 0 mA oder 10mA erzeugt werden, der Schalter arbeitet dann quasi in Phasenanschnitt.

Das Signal b "Nachladeanforderung" kann alternativ auch zeitgesteuert generiert werden.

In Fig. 4 ist nun ein alternativer Aufbau des Nachladeinitiators 16 für die Ausführung des Schalters 1 veranschaulicht, der seine Nachladevorgänge mit fest vorgegebener Periode durchführt. Hierbei enthält der Nachladeinitiator 16 die Blöcke Rampengenerator 48 und Steuerlogik 50.

Der Rampengenerator 48 erzeugt an seinem Ausgang 48a das Signal Rampenspannung U_{R} Dieses Signal steigt jeweils von 0 V bis maximal U_{B}. Tritt am Eingang 48b ein "Spannungsschwellwertimpuls" auf (Laststromschwellwertimpulse werden hier nicht benötigt), wird U_{R} auf 0 V gesetzt. Darauf steigt das Signal innerhalb der vorgegebenen Nachladeperiode gegen U_{B}.

Die Steuerlogik 50 erhält am Eingang 50a das Signal U_{R}, am Eingang 50b das Signal "Schalter ein/aus" sowie am Eingang 50c eine Referenzspannung U_{Ref}, die im Bereich zwischen 0 V und U_{B} (0 V < U_{Ref} < U_{B}) liegt. Nur wenn das Signal "Schalter ein/aus" den EIN-Zustand angibt, wird das Signal "Schaltelement ein/aus" am Ausgang 50d in Abhängigkeit der Nachladevorgänge auf AUS geschaltet. Ein Nachladevorgang wird eingeleitet, wenn das Signal U_{R} die Referenzspannung U_{Ref} überschreitet. Während des Nachladens fällt am Schalter die um U_{B} erhöhte Spannung ab. Sobald der Laststrom seinen Nulldurchgang hat, wird auch diese Spannung Null. Der Stromnulldurchgang kann somit über einen Spannungsnulldurchgang erkannt werden. Bei diesem Nulldurchgang werden die Schaltelemente im Block Schalteinrichtung 2 wieder eingeschaltet, der Nachladevorgang dadurch beendet. Ebenso wird das Signal U_{R} wieder zu 0 V gesetzt. Das Signal U_{R} wird nur bei Nachladevorgängen zu Null gesetzt. Stromnulldurchgänge, die bei eingeschalteten Schaltelementen der Schalteinrichtung 2 auftreten, erzeugen aufgrund des dann kleinen Spannungsabfalls am Schalter keinen Nulldurchgangsimpuls. Die Schaltvorgänge im Schalter sind in Fig. 8 dargestellt (Diagramme c, d, e entsprechen Fig. 6, c, d, e).

Um nicht zuviel Halbwellenstrom über den alternativen Strompfad 10a und Spannungspufferung 8 fließen zu lassen, wird der Nachladevorgang vorzugsweise kurz vor einem Nulldurchgang eingeleitet, insbesondere etwa 1 bis 2 ms. Die Anstiegsdauer des Signals U_{R} von 0 V bis U_{Ref} ist an die gewünschte Nachladeperiode angepasst und diese wiederum hängt vom tatsächlichen Energiebedarf ab. Um Unsymmetrien im Laststrom zu vermeiden, wird die Nachladeperiode so gewählt, daß die Nachladevorgänge in alternierenden Stromhalbwellen durchgeführt werden.

Es sollen nun die detaillierteren Schaltbilder ab Fig. 9 genauer erläutert werden.

Gemäß Fig. 9 besteht die Schalteinrichtung 2 aus zwei antiseriell in Reihe geschalteten MOSFETs oder IGBTs Q1 und Q2. Diese sind an ihren Source- bzw. Emitteranschlüssen miteinander verbunden und bilden die Schaltermasse 0 V.Optional können hier zur Laststromwertmessung zwei Widerstände R1 und R2 mit kleinem Widerstandswert (etwa 0,1 Ω) eingefügt sein, was aber bei der im Folgenden beschriebenen Schaltungsvariante nicht vorgesehen ist. Die Widerstände sind deshalb in Fig. 9 in Klammem gesetzt. Die Drain- bzw. Kollektoranschlüsse sind jeweils mit den Schalterklemmen A, B verbunden. Die Dioden D1, D2, D3 und D4 bilden einen Brückengleichrichter zur Gleichrichtung der Spannung U_{AC} zur Eingangsgleichspannung U_{DC}. D1 und D2 werden dabei durch die Inversdioden von Q1 und Q2 realisiert, sofern diese durch MOSFETs gebildet sind. Im AUS-Zustand und während des Nachladevorgangs sind Q1 und Q2 hochohmig (geöffnet). Der positive Versorgungs- bzw. Laststrom fließt von der Phase der Netzspannung kommend über D3 zum Block Strompfad 10, Spannungsversorgung 6 und über D2 zurück über die Last zum Nulleiter. Der negative Versorgungs- bzw. Laststrom fließt von der Last kommend über D4 zum Strompfad 10 und zur Spannungsversorgung 6 und dann über D1 zur Phase. Sind Q1 und Q2 niederohmig (durchgeschaltet), fließt der positive Laststrom über Q1 und D2 in Richtung Last. Der negative Laststrom fließt von der Last kommend über Q2 und D1.

Die Gate-Anschlüsse von Q1 und Q2 sind miteinander verbunden. Sie werden vom Signal "Schaltelement ein/aus" über R3 aktiviert. Ist der Pegel dieses Signals zum Durchsteuern von Q1 und Q2 zu klein (da U_{B} nur etwa 3 bis 5 V beträgt), so sorgt der Treiber 26 für eine Pegelanpassung. R3 bildet in Verbindung mit einem Kondensator C2 einen Tiefpaß und sorgt vorteilhafterweise für ein "weiches" Ein- und Ausschalten von Q1 und Q2 zur Reduzierung steiler Stromflanken. Eine parallel zum Kondensator C2 liegende Z-Diode D5 hat eine Spannung von etwa 15 V und verhindert ein Überschreiten der Gate-Spannung oberhalb ihres erlaubten Maximalwertes von etwa ± 20 V.

Über eine Diode D14 wirkt das Signal "Schalter aus" direkt auf die Gate-Anschlüsse von Q1 und Q2. Im Normalbetrieb ist das Signal auf inaktiv und beeinflusst die Gate-Ansteuerung vom Treiber 26 her nicht. Im Falle eines Kurzschlusses wird das Signal LOW und zieht über D14 das Gate-Potential In Richtung 0 V, worauf Q1 und Q2 sperren. Sie werden in diesem Falle nicht über den Treiber 26 abgeschaltet, da das Entladen von C2 über R3 zu lange dauert und ein Kurzschluß die Halbleiter in dieser Zeit zerstören könnte.

Dieser dargestellte Aufbau der Schalteinrichtung 2 enthält fünf Messpunkte M1 bis M5, über die relevante Größen bzw. Signale abgenommen werden können.

Die Messpunkte M1 und M2 stimmen mit den Schalterklemmen A, B überein und entsprechen jeweils den Knoten Q1/D3 bzw. Q2/D4. An diesen Messpunkten läßt sich im AUS-Zustand jeweils der positive bzw. negative "Spannungswert" messen, womit ein Einschalten im Nulldurchgang der Netzspannung realisiert werden kann. Im EIN-Zustand fällt an diesen Messpunkten M1, M2 eine vom Laststrom herrührende Spannung ab, die an den ON-Widerständen von Q1 und Q2, (sofern MOSFET) aus dem Laststrom erzeugt wird und zu diesem proportional ist. So lassen sich an ihnen der positive bzw. negative "Laststromwert" sowie die "Kurzschluß- und Überlaststromwerte" zur Weiterverarbeitung in der Schaltung abnehmen.

Der Messpunkt M3 greift am Knoten D3/D4 ab. An ihm lassen sich im AUS-Zustand beide Halbwellen des "Spannungswertes" überwachen (weil gleichgerichtet) und im EIN-Zustand die "Kurzschluß- und Überlaststromwerte". Bedingt durch die Dioden D3 und D4 ist ein genaues Messen der "Laststromwerte" nicht möglich, da die durch den Laststrom hervorgerufene Spannung an Q1 und Q2 im Allgemeinen kleiner als die Diodenspannung von 0,7 V ist. Für die Realisierungsart "Nachladen mit fester Periode" (vgl. Fig. 4) wird an diesem Punkt auch die Schalterspannung während des Nachladens gemessen, um Q1 und Q2 im Nulldurchgang einschalten zu können.

Die Messpunkte M4 und M5 sind nur vorhanden, wenn die Widerstände R1 und R2 auch vorhanden sind. An diesen Messpunkten M4, M5 lassen sich im EIN-Zustand stromproportionale Spannungen "Laststromwerte" und "Kurzschluß- und Überlaststromwerte" jeweils für positive und negative Halbwelle messen. Dabei misst M4 den positiven Laststrom und M5 den negativen Laststrom, der aber bezogen auf die Schaltermasse positiv ist.

Alternativ zu der in Fig. 9 dargestellten Ausführung kann die Schalteinrichtung auch lediglich einen Halbleiterschalter im DC-Pfad eines Brückengleichrichters aufweisen. Dessen Drain- bzw. Kollektor-Anschluß ist dann mit dem positiven Ausgang des Brückengleichrichters verbunden, Source- bzw. Emitteranschluß sind optional über einen niederohmigen Widerstand (wie R1) mit dem negativen Ausgang verbunden. Der negative Ausgang bildet die Schaltermasse. Zwischen beiden Ausgängen wird die Spannung D_{DC} erzeugt. Auch in diesem Fall existieren Messpunkte an beiden Schalterklemmen (AC-Eingang des Brückengleichrichters entsprechend M1 und M2), am positiven Ausgang des Brückengleichrichters (entsprechend M3) und am niederohmigen Widerstand (entsprechend M4, M5).

In Fig. 10 ist der Treiber 26 dargestellt. Dieser Treiber ist nur vorhanden, wenn die Betriebsspannung U_{B} zur Ansteuerung der Schaltelemente zu klein ist. In diesem Fall ist auch der Spannungserhöher 14 gemäß Fig. 1 vorhanden (vgl. dazu auch Fig. 13), der die höhere Sapnnung U_{M} zur Ansteuerung der Schaltelemente erzeugt. In Abhängigkeit vom Signal "Schaltelement ein/aus" am Eingang 26a wird U_{M} zum Ausgang 26b durchgeschaltet. Der Treiber 26 enthält die in Fig. 10 dargestellte Halbleiterschaltung mit Schaltelementen Q3, Q4 und Q5. Ist das Signal "Schaltelement ein/aus" auf LOW-Pegel (0 V), so sperrt Q5. Der Gate-Anschluß von Q4 ist über einen Widerstand R6 an U_{M} geschaltet, so daß Q4 leitet. Q3 sperrt. Der Ausgang 26b hat LOW-Pegel.

Ist das Signal am Eingang 26a auf HIGH-Pegel (U_{B}), so leitet Q5. Die Gate-Anschlüsse von Q3 und Q4 werden gegen Masse geschaltet, so daß Q3 leitet und Q4 sperrt. Der Ausgang des Treibers 26 ist in diesem Fall U_{M}. Die Widerstände R4 und R5 verringern den Querstrom durch Q3 und Q4 während des Umschaltvorgangs, zu dem kurzzeitig beide Transistoren leitend sind.

In Fig. 11 ist der Block Strompfad 10 veranschaulicht. Der obere linke Teil der Schaltung stellt den im AUS-Zustand wirksamen hochohmigen Strompfad 10b dar. Er besteht aus zwei Schaltelementen Q6, Q7 und einer Widerstandsbeschaltung mit R8, R9 und R10 wie dargestellt. Dabei handelt es sich um eine Regelschaltung (Stromquelle), die den Versorgungsstrom im AUS-Zustand unabhängig von der Impedanz der Last weitgehend konstant hält. Von U_{DC} kommend, wird über R9 und Q7 ein Grundstrom eingestellt, dessen Wert vorzugsweise nur einige 10 µA beträgt und zur Durchsteuerung von Q7 dient. Dieser Strom trägt nur wenig zum Aufbau der Betriebsspannung U_{B} bei. Über R10 wird der Versorgungsstrom eingestellt. Dieser berechnet sich aus dem Quotienten aus der weitgehend konstanten Basis-Emitter-Spannung von Q7 zu R10 (etwa 100 bis 300 µA). Q6 fängt die Differenzspannung aus U_{DC} minus (U_{Z} + U_{BE} (Q7)) auf. Bei U_{Z} handelt es sich um eine Zwischenspannung, die ebenso wie U_{BE} weitgehend konstant ist. U_{DC} hingehen ist eine pulsierende Gleichspannung, deren Scheitelwert lastabhängig ist. Ein Vorwiderstand R8 ist von kleinem Wert und schützt Q6 vor Überspannungen. Über einen weiteren Halbleiterschalter Q9 und einen Widerstand R11 wird in Abhängigkeit vom Signal "Reset" am Punkt P1 beim Hochfahren von U_{B} der Versorgungsstrom vergrößert. Ist "Reset" auf LOW-Pegel, so leitet Q9. R11 liegt dann parallel zu R10. R11 ist vom Wert her kleiner als R10 und bestimmt den Versorgungsstrom.

Der schon erwähnte, für die Nachladevorgänge im EIN-Zustand relevante alternative Strompfad 10a besteht aus dem Schaltelement Q8 (hier MOSFET), und einem Widerstand R15 sowie - je nach Ausführung - aus einem Treiber 52. Dieser hat grundsätzlich den gleichen Aufbau wie der oben beschriebene Treiber 26, doch wird er hier vom Signal "Schalter ein/aus" (Punkt P2) angesteuert. Hat dieses Signal HIGH-Pegel (U_{B}) wird Q8 mit U_{M} eingeschaltet. U_{M} ist in etwa dreimal so groß wie die Zwischenspannung U_{Z}, wenn U_{B} gleich 3 bis 5 V ist., so daß deren Differenz zur Durchsteuerung des MOSFET Q8 ausreicht. Mit einer Zener-Diode D8 wird auch hier Q8 vor Überspannungen geschützt. Mit dem Signal "Schalter aus" am Punkt P3 läßt sich über eine Diode D15 Q8 im Falle eines Kurzschlusses schnell ausschalten. Dazu entkoppeln R15 und D15 die Ausgangsspannung aus dem Treiber 52 vom Signal "Schalter aus" im EIN-Zustand. Ist das Signal "Schalter aus" inaktiv, wird die Ansteuerung von Q8 nur durch den Treiber 52 bestimmt. Hat es LOW-Pegel wird das Gate von Q8 gegen Masse geschaltet, so daß Q8 sperrt.

Statt eines MOSFET kann in geeigneter Weise auch ein PNP-Bipolartransistor für Q8 verwendet werden, doch ändert sich dann auch der Aufbau des Treibers und der Eingriffpunkt des Signals "Schalter aus".

Eine weitere Diode D6, über die die Spannung U_{DC} zugeführt wird, verhindert ein Rückkoppeln von Signalen aus dem Block 10 zum Messpunkt M3 hin (Fig. 9).

Gemäß Fig. 12 wird die Spannungsversorgung 6 im einfachsten Fall durch einen Pufferkondensator C1 als Spannungspufferung 8 und eine parallele Z-Diode D7 zur Stabilisierung der Spannung U_{B} gebildet. Der Kondensator C1 besitzt eine relativ hohe Kapazität von etwa 100 bis 470 µF. Der Strom durch die Z-Diode D7 zum Aufbau der Spannung U_{B} muß klein sein, da er den Vesorgungsstrom im AUS-Zustand erhöht, aber nicht zur Versorgung beiträgt. Für D7 kann in geeigneter Weise auch eine mit kleinem Strom betriebene Spannungsreferenz verwendet werden.

In Fig. 13 ist der optionale Spannungserhöher 14 dargestellt, der eingesetzt wird, wenn die gewählte Betriebspannung U_{B} nicht ausreicht, die Schaltelemente, wie MOSFETs oder IGBTS in den niederohmigen Zustand zu treiben. Der Spannungserhöher 14 sorgt in etwa für eine Verdreifachung der Betriebsspannung U_{B}. Über das Signal "Schalter ein/aus" am Eingang 14a wird der Spannungserhöher 14 im EIN-Zustand aktiviert. Ein Schmitt-Inverter G4 bildet zusammen mit R21 und C3 einen Rechteckoszillator, der.ein Rechtecksignal mit einer Frequenz von beispielsweise etwa 10 kHz erzeugt. Im AUS-Zustand ist der Eingang von G4 über eine Diode D13 gegen Masse geschaltet. In diesem Zustand kann er nicht schwingen und somit auch keinen Strom verbrauchen. Der Ausgang von G4 ist HIGH, der des nachgeschalteten G5 ist LOW. C4 und C6 sind dadurch auf U_{B} aufgeladen. C5 ist entladen. Wird die Oszillation im EIN-Zustand freigegeben, sorgt das gegenphasige Umschalten von G4 und G5 für ein wechselndes Übertragen der Ladungen von C5 nach C4 und von C4 nach C6. Die Spannung U_{B} in C5 wird dadurch zur Spannung U_{B} in C4 addiert, es entsteht nach einigen Schwingungen in etwa 2 x U_{B}, welche wiederum zur Spannung U_{B} in C6 addiert wird, so daß in etwa 3 x U_{B} erzeugt wird. Diese Spannung wird als U_{M} der weiteren Schaltung zur Verfügung gestellt.

In Fig. 14 ist bezüglich des zuvor fakultativ beschriebenen Kurzschluß- und Überlastschutzes 12 nur die Möglichkeit für einen Kurzschlußschutz dargestellt. Ein Überlastschutz wird bei der hier beschriebenen Realisierungsart auf einfache Weise an anderer Stelle erreicht. Es bleibt hier aber die Realisierung eines elektronischen Überlastschutzes in diesem Block vorbehalten.

Der Kurzschlußschutz benötigt nur ein Signal "Kurschlußstromwerte" vom Messpunkt M3. Hiermit überwacht er beide Netzhalbwellen. Steigt im Falle eines Kurzschlusses die Spannung am Schalter stark an, so wird ab einer Spannung von etwa 10 V über einen Spannungsteiler aus R22 und R23 ein Transistor Q10 eingeschaltet. Das Signal "Schalter aus" am Ausgang 12a wird dadurch gegen Masse geschaltet, was den Schalter dann in den AUS-Zustand versetzt.

Prinzipiell könnten auch andere Messpunkte zur Realisierung des Kurzschluß- und Überlastschutzes genutzt werden. Diese könnte zudem auch für positive und negative Halbwellen getrennt aufgebaut sein, so daß dann zwei Messsignale erforderlich wären.

In Fig. 15 ist ein Beispiel für die Sensorauswertung 36 dargestellt. Bei diesem Beispiel handelt es sich um einen Ein-Tasten-Umschalter, der bei (manueller) Betätigung in Abhängigkeit der Nulldurchgänge von Netzspannung und Laststrom das Signal "Schalter ein/aus" am Ausgang 36a erzeugt. Bei Betätigung eines Tasters S1 wird am Eingang von G1 eine negative Flanke erzeugt, die durch G1 invertiert wird. C7 reduziert das Schalterprellen. Die von G1 erzeugte positive Flanke invertiert den Zustand eines als Toggle-Flip-Flop geschalteten IC1A. Zum Einschalten wird ein Ausgang Q von IC1A dann HIGH. Mit dem nächsten "Spannungsschwellwertimpuls" am Eingang 36b eines Nulldurchgangs der Netzspannung wird dieser Zustand von IC1B übernommen; das Signal "Schalter ein/aus" am Ausgang 36a nimmt den EIN-Zustand an. Zum Ausschalten wird Ausgang Q von IC1A LOW. Mit dem nächsten "Laststromschwellwertimpuls" einer Über- bzw. Unterschreitung eines Schwellwertes durch den Laststrom wird dieser Zustand von IC1B B übernommen, das Signal "Schalter ein/aus" nimmt den AUS-Zustand an. Ist das Signal "Reset" am Eingang 36c auf LOW (0 V), werden beide Flip-Flops zurückgesetzt, d. h. beide Q-Ausgänge geben LOW-Pegel aus, der Schalter ist dann im AUS-Zustand.

Fig. 16 zeigt die Reset-Schaltung 34 aus Fig. 2. Die Reset-Schaltung 34 bringt den Schalterl beim Hochfahren der Betriebsspannung und bei Kurzschluß bzw. Überlast in den AUS-Zustand. Ein Spannungsteiler bestehend aus R25, R26 und NTC1 ist so dimensioniert, daß er die Spannung U_{BE} eines.Transistors Q11 unterhalb von 0,6 V hält, solange die Betriebsspannung U_{B} beim Hochfahren kleiner als 3 V ist. Dadurch sperrt Q11 zunächst. Die Basis von Q12 liegt dann über R27 am Potential U_{B}. Sobald U_{B} beim Hochfahren in etwa 0,7 V überschreitet, leitet Q12 und schaltet den Ausgang "Reset" 34a gegen Masse. Der Schalter wird dadurch in den AUS-Zustand versetzt. Sobald U_{B} eine Schwelle von 3 V überschreitet, leitet Q11 und schaltet die Basis von Q12 gegen Masse. Q12 sperrt, so daß das Signal "Reset" wieder zurückgenommen wird.

Im Falle eines Kurzschlusses oder einer Überlast schaltet das LOW-aktive Signal "Schalter aus" am Eingang 34 b das Signal "Reset" auf LOW (0 V). Der Schalter geht dann in den AUS-Zustand. Damit vom "Kurzschluß- und Überlastschutz" eventuell erkannte Kurzschlüsse oder Überlastungen, die kurzzeitig durch Einschaltströme oder höhere Spannungen an den Schalterklemmen beim Einschaltvorgang auftreten können, nicht zu einem Abschalten des Schalters führen, wird das Signal "Schalter aus" vom Eingang 34b und bevorzugt über eine Diode D17 zuerst über Q13 vom Signal "Reset" (Ausgang 34a) getrennt. Der Transistor Q13 wird vom Signal "Schalter ein/aus" vom Eingang 34c über einen Tiefpass aus R29 und C8 leicht verzögert eingeschaltet, wodurch ein sicherer Übergang des Schalters in den EIN-Zustand gegeben ist.

Der temperaturabhängige Widerstand NTC1 hat einen negativen Temperaturkoeffizienten und wird im Schaltungslayout bevorzugt in der Nähe der Leistungstransistoren Q1 und Q2 untergebracht. Dies ergibt eine vorteilhaft einfache Möglichkeit für einen Überlastschutz. Bei Überschreitung einer maximal erlaubten Temperatur der Schaltelemente Q1, Q2 im EIN-Zustand verringert NTC1 seinen Widerstand, so daß Q11 sperrt und Q12 leitet. Das Signal "Reset" hat dann LOW-Pegel, der Schalter geht in den AUS-Zustand.

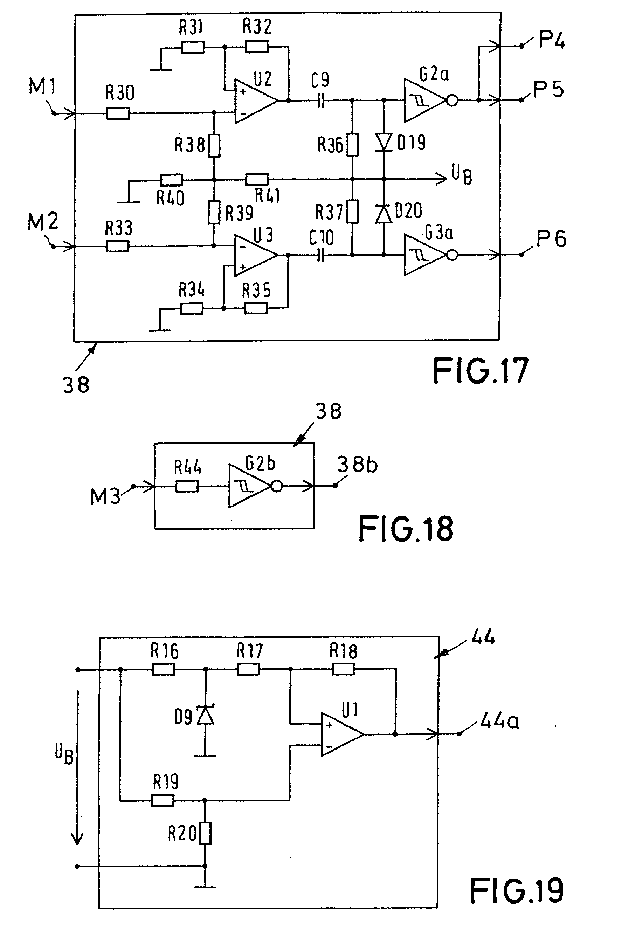

In Fig. 17 ist eine erste Ausführung der Schwellwerterkennung 38 aus Fig. 2 dargestellt Diese Ausführung kommt bei den Schalter-Ausführungsvarianten 1, 2 und 3 zum Einsatz und wertet die Signale an den Messpunkten M1 und M2 aus. Im AUS-Zustand werden aus definierten Netzspannungsschwellen Impulse generiert. Im EIN-Zustand fällt an den Messpunkten eine kleine, zum Laststrom proportionale Spannung ab. Aus dieser erzeugt die Schaltung je nach Arbeitspunkteinstellung die Laststromschwellwertimpulse.

Der dargestellte symmetrische Aufbau dieser Schwellwerterkennung 38 ist nur erforderlich, wenn die Nachladevorgänge bedarfsabhängig und in der Nähe von Laststromnulldurchgängen mit alternierender Polarität- durchgeführt werden sollen (Ausführungsvariante 3). Dann erzeugen Nulldurchgänge mit positiver und negativer Steigung jeweils die getrennten Signale "Laststromschwellwertimpulse (positive Halbwelle)" am Ausgangspunkt P5 bzw. "Laststromschwellwertimpulse (negative Halbwelle)" am Ausgangspunkt P6, die von der nachfolgenden Schalterung alternierend für die Nachladevorgänge genutzt werden. Für die oben beschriebene Schaltungsvariante 2, wobei immer in Laststromhalbwellen gleicher Polarität nachgeladen wird, kann der untere Schaltungsbereich entfallen (bestehend aus R33, R39, U3, R34, R35, C10, R37, D20 und G3a).

Erläutert wird im Folgenden nur der obere Schaltungsteil in Fig. 17. Über einen Widerstand R30 werden die Signale vom Messpunkt M1 sehr hochohmig ausgekoppelt (R30 > 4MΩ). Der Ruhestrom über R30 im AUS-.Zustand addiert sich zu dem Versorgungsstrom hinzu, sorgt aber nicht für ein Nachladen der Spannungspufferung 8. Das ausgekoppelte Signal wird einem Komparator zugeführt, bestehend aus U2, R31 und R32. Dieser hat eine kleine Hysterese und ändert sein Ausgangssignal in den Nulldurchgängen. Bei negativer Halbwelle gibt U2 HIGH-Pegel (U_{B}) aus, bei positiver Halbwelle gibt U2 LOW-Pegel (0 V) aus. Am invertierenden Eingang von U2 befinden sich bevorzugt - hier nicht eingezeichnete - Schutzdioden, die den Eingang vor Übersteuerung durch die am Schalter anliegende Netzspannung im AUS-Zustand schützen.

Bei Überwachung des Laststroms kann dem ausgekoppelten Signal über R38, R40 und R41 ein Spannungs-Offset zugeführt werden, so daß der Komparator nicht genau im Stromnulldurchgang umschaltet, sondern bei Werten, die vom Betrag her größer Null sind. Dies ist vorteilhaft bei Energiesparlampen, da diese keinen kontinuierlichen Laststrom, sondern pro Halbwelle nur einen Laststromimpuls aufweisen. Zwischen diesen Impulsen beträgt der Laststrom jeweils Null. Dieser Nullstrom würde - bedingt durch sein Rauschen - zu einer Störung der Schwellwerterkennung führen. Der Strom, ab dem die Schwellwerterkennung umschalten soll, wird durch die Offset-Schaltung beispielsweise auf 10 mA festgelegt. Allerdings sind auch andere Werte möglich.

Überschreitet der Laststrom bei positiver Steigung den Schwellwert (von beispielsweise 10 mA), schaltet U2 von HIGH auf LOW. Da C9 noch entladen ist, ist auch der Eingang von G2a LOW, so daß der Ausgang von G2a von LOW auf HIGH umschaltet. C9 lädt sich dann innerhalb von etwa 1ms über R36 auf Betriebsspannung U_{B} auf. G2a wechselt daraufhin sein Ausgangssignal wieder auf LOW. Somit ist ein "Laststromschwellwertimpuls" erzeugt. Schaltet U2 wieder auf HIGH, ändert sich der Ausgang von G2a nicht, da sein Eingang auf HIGH bleibt. Die Diode D19 schützt den Eingang von G2a.

Im AUS-Zustand werden bei Spannungsnulldurchgang mit positiver Steigung "Spannungsschwellwertimpulse" erzeugt. Der Offset hat hier - bedingt durch den im AUS-Zustand viel größeren Spannungspegel am Messpunkt M1 - keinen Einfluss.

Fig. 18 zeigt die Alternative der Schwellwerterkennung 38 für die Schaltervariante 4 (Nachladevorgänge mit fest vorgegebener Periode per Phasenabschnitt). In diesem Fall besteht die Schwellwerterkennung 38 lediglich aus einem Widerstand R44 und dem Schmitt-Inverter G2b. R44 ist mit dem Messpunkt M3 verbunden, an dem die gleichgerichtete Schalterklemmspannung U_{DC} anliegt. Ist diese größer als die halbe Betriebsspannung U_{B}, gibt G2b LOW-Pegel aus. Ist sie kleiner, gibt G2b HIGH-Pegel aus. Letzteres ist im AUS-Zustand immer in den Nulldurchgängen der Netzspannung bzw. im EIN-Zustand beim Nachladevorgang, während dessen am Schalter die erhöhte Spannung abfällt, der Fall. Mit dem auf den Nachladevorgang folgenden Stromnulldurchgang wechselt G2b wieder auf HIGH-Pegel, den er bis zum nächsten von dem Nachladeinitiator eingeleiteten Nachladevorgang beibehält. Die beim Stromnulldurchgang erzeugte positive Flanke von G2b wird von der weiteren Schaltung ausgewertet, die Schaltelemente in 2 werden wieder eingeschaltet. Im EIN-Zustand wird hier ein zum Signal c in Fig. 8 invertiertes Signal erzeugt. Nicht dargestellte Schutzdioden im Eingang von G2b verhindern ein Übersteuern des Eingangs durch die hohe Spannung am Messpunkt M3.

Fig. 19 zeigt ein Schaltungsbeispiel für die Spannungsüberwachung 44 in Fig. 3. Durch eine Überwachung der Betriebsspannung U_{B} wird hier am Ausgang 44a das Signal "Nachladeanforderung" erzeugt, und zwar für alle Schaltervarianten, wobei die Nachladevorgänge bedarfsorientiert veranlasst werden. Die Betriebsspannung U_{B} wird dazu über einen Spannungsteiler aus R19 und R20 auf einen Wert etwa im Bereich der Z-Spannung von D9 heruntergeteilt. Die Z-Diode D9 ist dazu idealerweise eine Spannungsreferenz, die mit einem sehr kleinen Strom (nur einige 10*µ*A) eine sehr konstante Spannung erzeugt. Unterschreitet die Spannung U_{B} einen Wert von beispielsweise 4,5 V, sinkt die Spannung an R20 unter die Z-Spannung von D9. Ein Komparator U1 gibt darauf HIGH-Pegel aus und signalisiert den Bedarf eines Nachladevorgangs. Während des Nachladens steigt U_{B} wieder an. Bedingt durch die Hysterese aus R17 und R18 schaltet der Komparator U1 erst ab einer Schwelle von beispielsweise U_{B} = 5 V zurück auf LOW-Pegel. Der Nachladevorgang wird dann beendet.

Die Spannungsüberwachung kann auch durch eine Zeitsteuerung ersetzt werden, welche das Ausgangssignal (Ausgang 44a) entsprechend nachbildet.

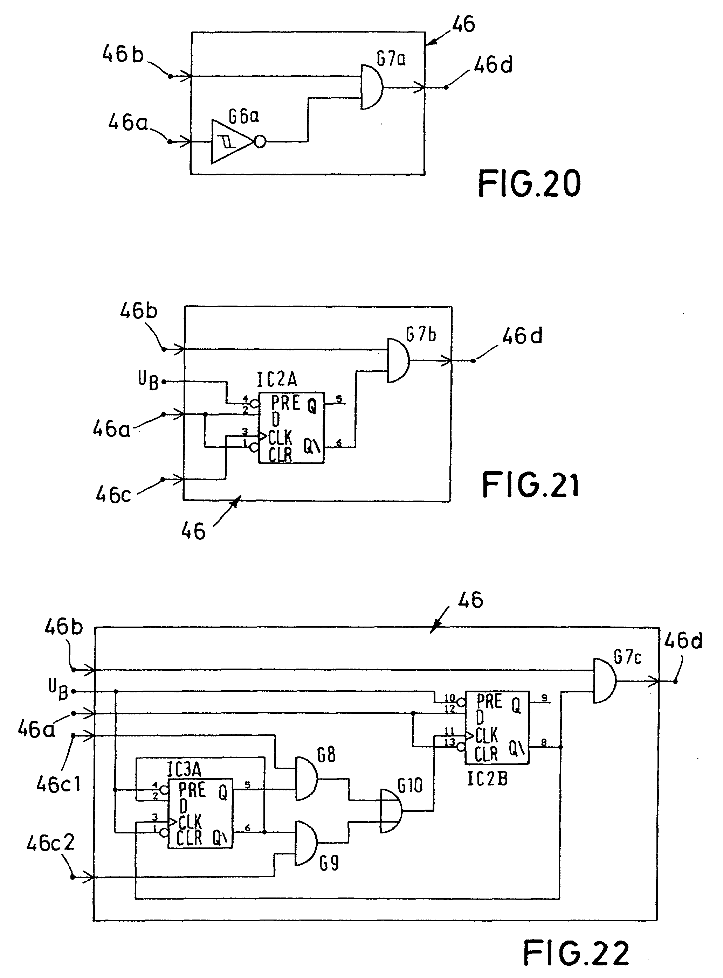

Die weiteren Figuren 20 bis 22 zeigen drei Varianten für die Steuerlogik 46 aus Fig. 3. Die erste Variante gemäß Fig. 20 leitet im EIN-Zustand die Nachladevorgänge bei Bedarf zu beliebigen Phasenwinkeln des Laststromes ein. Dazu werden die Schaltelemente der Schalteinrichtung 2 über ein UND-Gatter G7a angesteuert. Ist das Signal "Schalter ein/aus" am Eingang 46b auf LOW, ist G7a gesperrt und das Signal "Schaltelement ein/aus" ist ebenfalls LOW am Ausgang 46d. Im EIN-Zustand ist das Signal "Schaltelement ein/aus" direkt abhängig vom Signal "Nachladeanforderung" am Eingang 46a. Besteht keine Nachladeanforderung, gibt G6a HIGH-Pegel aus, der sich auf den Ausgang von G7a überträgt. Wird die "Nachladeanforderung" HIGH, gibt G6a LOW aus, das Signal "Schaltelement ein/aus" geht ebenfalls zu LOW, der Nachladevorgang wird direkt, unabhängig von der Phasenlage eingeleitet.

Die in Fig. 21 dargestellte zweite Variante der Steuerlogik 46 leitet im EIN-Zustand die Nachladevorgänge bei Bedarf nach Nulldurchgängen gleicher Polarität ein. Die Funktion ist zunächst ähnlich wie in Fig. 20, doch wird hier die "Nachladeanforderung" über Eingang 46a nicht direkt an das Gatter G7b geführt, sondern über ein Flip-Flop IC2A. Solange "Nachladeanforderung" LOW ist, ist IC2A über den Reset-Eingang CLR zurückgesetzt. Der Ausgang Q\ und das Signal "Schaltelement ein/aus" am Ausgang 46d sind HIGH. Wird "Nachladeanforderung" am Eingang 46a HIGH, so wird dieser Zustand erst beim folgenden, auf den Clock-Eingang CLK wirkenden "Laststromschwellwertimpuls" (positive Halbwelle)" (Eingang 46c) vom Flip-Flop übernommen. Ausgang Q\ und der Ausgang von G7b werden LOW. Wenn "Nachladeanforderung" am Eingang 46a auf LOW zurückgeht, wird IC2A sofort zurückgesetzt und der Nachladevorgang beendet.

In einem nicht dargestellten, alternativen Aufbau dieser Schaltung kann beim Nachladen auch eine komplette Periode des Laststromes über den alternativen Strompfad 10a geschickt werden. Dazu wird der Reset-Eingang CLR auch an U_{B} geschaltet. Es wird dann, nachdem das Signal "Nachladeanforderung" wieder LOW-Pegel hat, zum Wiedereinschalten der Schaltelemente der Schalteinrichtung 2 auf den nächsten folgenden "Laststromschwellwertimpuls (positive Halbwelle)" gewartet. Die Spannungspufferung 8 hat dann vorteilhafterweise zur Ausnutzung des langen Nachladevorgangs eine sehr hohe Kapazität. Vorteil dieser Schaltungsvariante ist, daß die Periode der aufeinanderfolgenden Nachladevorgänge sehr lang ist (Sekundenbereich), so daß die Anzahl der Nachladevorgänge reduziert wird. Die Betriebsspannung U_{B} muß dazu möglichst klein sein, da sie während des Nachladens als Gegenspannung zur Netzspannung wirkt, was die Spannung an der Last reduziert.

Fig. 22 zeigt eine dritte Variante der Steuerlogik 46, die im EIN-Zustand die Nachladevorgänge bei Bedarf nach Nulldurchgängen mit alternierender Polarität einleitet. Hier werden dazu die "Laststromschwellwertimpulse" von positiver und negativer Halbwelle genutzt (Eingänge 46c1, 46c2). Diese werden hier nicht direkt an den Clock-Eingang CLK von IC2B geschaltet, sondern über einen Wechsler, bestehend aus IC3A, G8, G9 und G10, der die Schwellwertimpulse abwechselnd weiterleitet. IC3A ist dazu als Toggle-Flip-Flop geschaltet. Nach jedem Nachladevorgang ändert es mit der positiven Flanke des Ausgangs Q\ von IC2B seinen Zustand. Ist Ausgang Q von IC3A HIGH und Q\ LOW wird nur der "Laststromschwellwertimpuls (positive Halbwelle)" vom Eingang 46C1 über das UND-Gatter G8 und das ODER-Gatter G10 zum Eingang CLK von IC2B weitergeleitet. Da ein Eingang von G9 LOW-Pegel hat, wird das Signal "Laststromschwellwertimpuls (negative Halbwelle)" vom Eingang 46c2 nicht weitergeleitet. Bei Nachladeanforderung wird dann auf den "Laststromschwellwertimpuls (positive Halbwelle)" am Eingang 46c1 gewartet. Da der Zustand von IC3A nach erfolgtem Nachladevorgang invertiert wird (Q ist LOW, Q\ ist HIGH), wird der Nachladevorgang bei der folgenden Nachladeanforderung auf den "Laststromschwellwertimpuls (negative Halbwelle)" eingeleitet.

Wird der Eingang CLR von IC2B statt an "Nachladeanforderung" auf HIGH-Pegel gelegt (U_{B}) und zwischen Ausgang Q\ von IC2B und Eingang CLK von IC3A ein Invertierer geschaltet, können zum Nachladen komplette Halbwellen mit alternierender Polarität über den alternativen Strompfad geschickt werden. Der Invertierer sorgt für ein direktes Toggeln von IC3A nach Einleitung des Nachladevorgangs, der dann mit dem "Laststromschwellwertimpuls" der Halbwelle mit entgegengesetzter Polarität beendet wird. Auch hier hat dann der Pufferkondensator C1 (Fig. 12) eine große Kapazität.

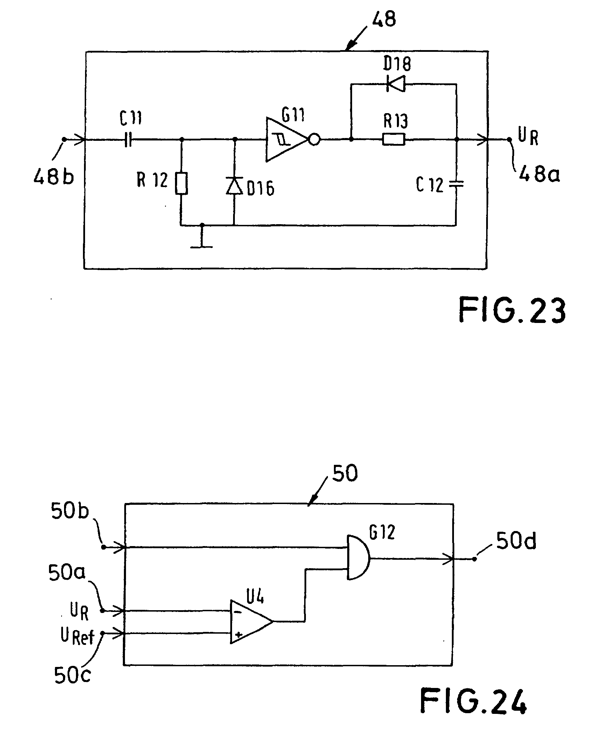

Fig. 23 zeigt ein Ausführungsbeispiel für den Rampengenerator 48 nach Fig. 4, der für die Schaltervariante mit zeitgesteuerter Nachladung relevant ist. Ein Spannungsnulldurchgang am Messpunkt M3 setzt die Rampenspannung U_{R} zu Null. Der Spannungsnulldurchgang entspricht einem Stromnulldurchgang, der nur erkannt wird, wenn gerade ein Nachladevorgang bei höherer Schalterspannung stattfindet. Die von der "Spannungsschwellwerterkennung" 38 (vgl. Fig. 2) erzeugte, positive Flanke im Spannungsnulldurchgang wird vom Eingang 48b über ein Gatter G11 invertiert. Diese steigende Flanke entlädt einen Kondensator C12 schnell über D18, so daß die Spannung U_{R} am Ausgang 48a Null wird. Während des weiteren HIGH-Verlaufs des "Spannungsschwellwertimpulses" lädt sich C11 über R12 schnell auf, der Eingang von G11 wird LOW, der Ausgang von G11 wird HIGH. C12 wird ab jetzt stetig über R13 bis maximal auf Betriebsspannung U_{B} aufgeladen. Die fallende Flanke des "Spannungsschwellwertimpulses" hat keinen Einfluss auf den Zustand von G11, der Ausgang bleibt HIGH. Über D16 wird C11 nach der fallenden Flanke des "Spannungsschwellwertimpulses" schnell entladen.

In Fig. 24 schließlich ist ein Beispiel für die Steuerlogik 50 gemäß Fig. 4 dargestellt. Die Schaltelemente der Schalteinrichtung 2 werden über ein UND-Gatter G12 angesteuert. Ist das Signal "Schalter ein/aus" am Eingang 50b auf LOW, ist G12 gesperrt, so daß das Signal "Schaltelemente ein/aus" am Ausgang 50d ebenfalls LOW ist. Im EIN-Zustand ist das Signal "Schaltelemente ein/aus" direkt abhängig vom Ausgangssignal des Komparators U4. Solange U_{R} kleiner als die Referenzspannung U_{Ref} ist, ist der Ausgang von U4 HIGH. Sobald U_{R} die Referenzspannung U_{Ref} übersteigt, schalten U4 und damit G12 auf LOW, die Schaltelemente im Block Steuereinrichtung 2 werden abgeschaltet.

Die Erfindung ist nicht auf die dargestellten und beschriebenen Ausführungsbeispiele beschränkt, sondern umfasst auch alle im Sinne der Erfindung gleichwirkenden Ausführungen. Ferner ist die Erfindung bislang auch noch nicht auf die im Anspruch 1 definierte Merkmalskombination beschränkt, sondern kann auch durch jede beliebige andere Kombination von bestimmten Merkmalen aller insgesamt offenbarten Einzelmerkmalen definiert sein. Dies bedeutet, daß grundsätzlich praktisch jedes Einzelmerkmal des Anspruchs 1 weggelassen bzw. durch mindestens ein an anderer Stelle der Anmeldung offenbartes Einzelmerkmal ersetzt werden kann. Insofern ist der Anspruch 1 lediglich als.ein erster Formulierungsversuch für eine Erfindung zu verstehen.

## Patentansprüche

1. Elektronischer Schalter mit Zweidrahtanschluß (A, B) zum Schalten von Lasten (L) mit niedriger oder hoher Impedanz, wie Glühlampen oder Leuchtstofflampen, mit folgenden Komponenten:
einer zum Ein- oder Ausschalten der Last (L) ansteuerbaren Schalteinrichtung (2) mit mindestens einem in Reihe zu der Last (L) und an einer Schalter-Eingangswechselspannung (U_{AC}) liegenden Schaltelement (Q1, Q2),
einer Steuerschaltung (4) zum Ansteuern der Schalteinrichtung (2) und
einer Spannungsversorgung (6) zur internen Schalter-Eigenversorgung mit einer Betriebsgleichspannung (U_{B}) aus der Eingangswechselspannung (U_{AC}) mittels einer über die Last (L) nachladbaren Spannungspufferung (8),
**gekennzeichnet durch** einen Nachladeinitiator (16), der zur Eigenversorgung im eingeschalteten Zustand der Last (L) in an den inneren Energiebedarf angepassten Zeitabständen jeweils einen Nachladevorgang der Spannungspufferung (8) auslöst, indem jeweils kurzzeitig die Schalteinrichtung (2) zum Abschalten angesteuert und die Betriebsgleichspannung (U_{B}) über einen alternativen Strompfad (10a) gewonnen wird.

2. Elektronischer Schalter nach Anspruch 1,
**dadurch gekennzeichnet,**
**daß** der Nachladeinitiator (16) die Nachladevorgänge jeweils bedarfsabhängig in Abhängigkeit von der Höhe der Betriebsgleichspannung (U_{B}) über eine Bedarfssteuerung auslöst.

3. Elektronischer Schalter nach Anspruch 2,
**dadurch gekennzeichnet,**
**daß** die Bedarfssteuerung eine Spannungsüberwachung (44) für die Betriebsgleichspannung (U_{B}) derart aufweist, daß bei Erreichen oder Unterschreiten eines bestimmten Schwellwertes der Betriebsgleichspannung (U_{B}) selbsttätig über den Nachladeinitiator (16) ein Nachladevorgang ausgelöst wird.

4. Elektronischer Schalter nach Anspruch 1,
**dadurch gekennzeichnet,**
**daß** der Nachladeinitiator (16) die Nachladevorgänge jeweils zeitgesteuert in vorbestimmten, an den Energiebedarf angepassten Zeitabständen über eine Zeitsteuerung auslöst.

5. Elektronischer Schalter nach einem der Ansprüche 1 bis 4,
**dadurch gekennzeichnet,**
**daß** die Schalteinrichtung (2) eine Gleichrichterbeschaltung (D1 bis D4) derart aufweist, daß im jeweils abgeschalteten Zustand die Eingangswechselspannung (U_{AC}) zu der Eingangsgleichspannung (U_{DC}) gleichgerichtet und diese zu der Betriebsgleichspanung (U_{B}) weiterverarbeitet wird.

6. Elektronischer Schalter nach einem der Ansprüche 1 bis 5,
**dadurch gekennzeichnet,**
**daß** im ausgeschalteten Zustand der Last (L) ein über die Last (L) fließender, geringer Versorgungsstrom zur Erzeugung der Betriebsgleichspannung (U_{B}) über einen hochohmigen Strompfad (10b) fließt, wobei vorzugsweise der Versorgungsstrom über eine Stromquelle (18) nahezu unabhängig von der Impedanz der jeweiligen Last (L) im Wesentlichen konstant gehalten wird.

7. Elektronischer Schalter nach einem der Ansprüche 1 bis 6,
**dadurch gekennzeichnet,**
**daß** bei den im eingeschalteten Zustand der Last (L) durch den Nachladeinitiator (16) ausgelösten Nachladevorgängen jeweils das bzw. jedes Schaltelement (Q1, Q2) der Schalteinrichtung (2) weich, d. h. mit relativ flachen Schaltflanken, ausund eingeschaltet wird.

8. Elektronischer Schalter nach einem der Ansprüche 1 bis 7,
**dadurch gekennzeichnet,**
**daß** der Effektivwert einer Laststromhalbwelle, in der ein Nachladevorgang stattfindet, gegenüber dem Effektivwert einer regulären Laststromhalbwelle nur geringfügig, insbesondere um etwa 0,1 bis maximal 1 %, vermindert ist.

9. Elektronischer Schalter nach einem der Ansprüche 1 bis 8,
**dadurch gekennzeichnet,**
**daß** die Nachladevorgänge jeweils im Bereich eines Nulldurchgangs des Laststromes bzw. der Eingangswechselspannung (U_{AC}) ausgelöst werden, wobei insbesondere die Schalteinrichtung (2) zum Abschalten etwa im Nulldurchgang des Laststromes und zum Einschalten etwa im Nulldurchgang der Eingangswechselspannung (U_{AC}) angesteuert wird.

10. Elektronischer Schalter nach einem der Ansprüche 1 bis 9,
**gekennzeichnet durch** einen der Spannungspufferung (8) nachgeschalteten Spannungserhöher (14) zur Erzeugung einer erhöhten Steuerspannung (U_{M}) für die Schalteinrichtung (2) aus der Betriebsgleichspanung (U_{B}).

## Claims

1. Electronic switch having a two wire connection (A, B) for switching loads (L) with a low or high impedance, such as incandescent or fluorescent lamps, having the following components:
a switching device (2) which can be actuated to switch the load (L) on or off and has at least one switching element (Q1, Q2) which is connected in series with the load (L) and a switch input AC voltage (U_{AC}),
a control circuit (4) for actuating the switching device (2), and
a voltage supply (6) as an internal dedicated switch supply with an operating DC voltage (U_{B}) from the input AC voltage (U_{AC}) by means of a voltage buffer (8), which can be recharged via the load (L),
**characterized by** a recharging initiator (16) which in each case initiates a recharging process for the voltage buffer (8) for the dedicated supply when the load (L) is in the switched-on state, at time intervals which are matched to the internal energy requirement,
in that the switching device (2) is in each case briefly switched off and the operating DC voltage (U_{B}) is obtained via an alternative current path (10a).

2. Electronic switch according to Claim 1,
**characterized**
**in that** the recharging initiator (16) in each case initiates the recharging processes as required as a function of the magnitude of the operating DC voltage (U_{B}), via a requirement controller.

3. Electronic switch according to Claim 2,
**characterized**
**in that** the requirement controller has a voltage monitor (44) for the operating DC voltage (U_{B}) such that, when the operating DC voltage (U_{B}) reaches or falls below a specific threshold value, a recharging process is initiated automatically via the recharging initiator (16).

4. Electronic switch according to Claim 1,
**characterized**
**in that** the recharging initiator (16) in each case initiates the recharging processes on a time-controlled basis via a time controller at predetermined time intervals, which are matched to the energy requirement.

5. Electronic switch according to one of claims 1 to 4,
**characterized**
**in that** the switching device (2) has a rectifier circuit (D1 to D4) such that, in the respectively switched-off state, the input AC voltage (U_{AC}) is rectified to form the input DC voltage (U_{DC}), and this is further processed to form the operating DC voltage (U_{B}).

6. Electronic switch according to one of Claims 1 to 5,
**characterized**
**in that**, when the load (L) is in the switched-off state, a small supply current flowing via the load (L) flows via a high-impedance current path (10b) in order to produce the operating DC voltage (U_{B}), with the supply current via a current source (18) preferably being kept essentially constant, virtually independently of the impedance of the respective load (L).

7. Electronic switch according to one of Claims 1 to 6,
**characterized**
**in that** during the recharging processes which are initiated by the recharging initiator (16) when the load (L) is in the switched-on state, the or each switching element (Q1, Q2) of the switching device (2) is in each case switched off and on softly, that is to say with relatively flat switching flanks.

8. Electronic switch according to one of Claims 1 to 7,
**characterized**
**in that** the root mean square value of one load current half cycle, in which a recharging process takes place, is only slightly less than the root mean square value of a regular load current half cycle, in particular being reduced by about 0.1 to a maximum of 1%.

9. Electronic switch according to one of claims 1 to 8,
**characterized**
**in that** the recharging processes are each initiated in the region of a zero crossing of the load current or of the input AC voltage (U_{AC}), with, in particular, the switching device (2) being actuated to switch off approximately at the zero crossing of the load current and to switch on approximately at the zero crossing of the input AC voltage (U_{AC}).

10. Electronic switch according to one of Claims 1 to 9,
**characterized by** a voltage raising device (14), which is connected downstream from the voltage buffer (8), in order to produce an increased control voltage (U_{M}) for the switching device (2), from the operating DC voltage (U_{B}).

## Revendications

1. Commutateur électronique avec connexion à deux fils (A, B) pour la connexion de charges (L) de basse impédance ou de haute impédance comme des lampes à incandescence ou des lampes à luminescence, qui comprend les composants suivants:
un dispositif de commutation (2) pouvant être commandé pour la mise en circuit ou hors circuit de la charge (L), comprenant au moins un élément de commutation (Q1, Q2) monté en série avec la charge (L) et connecté à une tension alternative (U_{AC}) d'entrée du commutateur,
un circuit de commande (4) pour la commande du dispositif de commutation (2) et
une alimentation en tension (6) destinée à assurer l'alimentation interne propre du commutateur avec une tension continue de service (U_{B}) tirée de la tension alternative d'entrée (U_{AC}), au moyen d'un tampon de tension (8) qui peut être rechargé à travers la charge (L),
**caractérisé en ce qu'**à travers un initiateur de recharge (16) qui déclenche, pour l'alimentation propre à l'état mis en circuit de la charge (L), à des intervalles de temps adaptés à la demande d'énergie intérieure, un processus de récharge du tampon de tension (8) par le fait que le dispositif de commutation (2) est à chaque fois commandé brièvement pour la coupure et la tension continue de service (U_{B}) est obtenue par l'intermédiaire d'un autre trajet de courant (10a).

2. Commutateur électronique selon la revendication 1,
**caractérisé en ce que** l'initiateur de recharge (16) déclenche les processus de recharge, à chaque fois à la demande, en fonction de la hauteur de la tension continue de service (U_{B}) par l'intermédiaire d'une commande de demande.

3. Commutateur électronique selon la revendication 2,
**caractérisé en ce que** la commande de demande présente une surveillance de tension (44) pour la tension continue de service (U_{B}), de telle manière que lorsqu'une certaine valeur de seuil déterminée de la tension continue de service (U_{B}) est atteinte ou dépassée, un processus de recharge est déclenché automatiquement par l'intermédiaire de l'initiateur de recharge (16).

4. Commutateur électronique selon la revendication 1,
**caractérisé en ce que** l'initiateur de recharge (16) déclenche les processus de recharge, à chaque fois de façon commandée dans le temps, à des intervalles de temps prédéterminés, adaptés à la demande d'énergie, au moyen d'une commande à temps.

5. Commutateur électronique selon une des revendications 1 à 4,
**caractérisé en ce que** le dispositif de commutation (2) présente un circuit redresseur (D1 à D4) de telle sorte qu'à l'état coupé, la tension alternative d'entrée (U_{AC}) est redressée pour donner la tension continue d'entrée (U_{DC}) et cette dernière subit un nouveau traitement pour donner la tension continue de service (U_{B}).

6. Commutateur électronique selon une des revendications 1 à 5,
**caractérisé en ce qu'**à l'état, déconnecté de la charge (L), un faible courant d'alimentation, qui traverse la charge (L) circule pour la production de la tension continue de service (U_{B}) en passant par un trajet de courant à haute valeur ohmique (10b), cependant que le courant d'alimentation est de préférence maintenu sensiblement constant au moyen d'une source de courant (18), de façon presque indépendante de l'impédance de la charge (L) considérée.

7. Commutateur électronique selon une des revendications 1 à 6,
**caractérisé en ce que**, dans les processus de recharge déclenchés par l'initiateur de recharge (16) à l'état mis en circuit de la charge (L), l'élément de commutation ou chaque élément de commutation (Q1, Q2) du dispositif de commutation (2) est mis hors circuit et en circuit de façon progressive, c'est-à-dire avec des flancs de commutation à pente relativement faible.

8. Commutateur électronique selon une des revendications 1 à 7,
**caractérisé en ce que** la valeur effective d'une demi-onde du courant de charge dans laquelle se trouve un processus de recharge n'est réduit que dans une faible mesure, en particulier d'environ 0,1% à 1% au maximum, comparativement à la valeur effective d'une demi-onde normale du courant de charge.

9. Commutateur électronique selon une des revendications 1 à 8,
**caractérisé en ce que** les processus de recharge sont déclenchés à chaque fois dans la région d'un passage par zéro du courant de charge ou de la tension alternative d'entrée (U_{AC}), le dispositif de commutation (2) étant commandé pour la mise hors circuit à peu près au passage par zéro du courant de charge et pour la mise en circuit à peu près au passage par zéro de la tension alternative, d'entrée (U_{AC}).

10. Commutateur électronique selon une des revendications 1 à 9,
**caractérisé par** un élévateur de tension connecté en aval du tampon de tension (8) et destiné à produire une tension de commande (U_{M}) plus élevée pour le dispositif de commutation (2) à partir de la tension continue de service (U_{B}).
